(19)

**Europäisches Patentamt**
**European Patent Office**
**Office européen des brevets**

(11) **EP 3 812 777 B1**

(12) **EUROPEAN PATENT SPECIFICATION**

(45) Date of publication and mention
of the grant of the patent:
**22.10.2025 Bulletin 2025/43**

(21) Application number: **19823205.0**

(22) Date of filing: **29.05.2019**

(51) International Patent Classification (IPC):
*G01R 31/36* (2020.01)       *G01R 31/367* (2019.01)
*G01R 31/387* (2019.01)

(52) Cooperative Patent Classification (CPC):
**G01R 31/367; G01R 31/387; G01R 31/389**

(86) International application number:
**PCT/CN2019/088992**

(87) International publication number:
**WO 2019/242472 (26.12.2019 Gazette 2019/52)**

(54) **METHOD AND DEVICE FOR ESTIMATING BATTERY CHARGE STATUS**

VERFAHREN UND VORRICHTUNG ZUR SCHÄTZUNG DES BATTERIELADEZUSTANDS

PROCÉDÉ ET DISPOSITIF ESTIMATION D'ÉTAT DE CHARGE DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.06.2018 CN 201810634553**

(43) Date of publication of application:
**28.04.2021 Bulletin 2021/17**

(73) Proprietor: **HUAWEI TECHNOLOGIES CO., LTD.
Shenzhen, Guangdong 518129 (CN)**

(72) Inventors:
• **LI, Juan
Shenzhen, Guangdong 518129 (CN)**
• **LI, Hui
Shenzhen, Guangdong 518129 (CN)**
• **FAN, Tuanbao
Shenzhen, Guangdong 518129 (CN)**
• **LI, Yangxing
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(56) References cited:
EP-A1- 2 439 550          WO-A1-2017/135075
WO-A1-2017/183241          CN-A- 101 303 397
CN-A- 101 598 769          CN-A- 102 756 661
CN-A- 104 111 377          CN-A- 106 054 080
CN-A- 106 067 560          US-A1- 2002 195 999
US-A1- 2003 236 656          US-A1- 2011 148 424
US-A1- 2013 185 008          US-A1- 2014 222 358

• **VERBRUGGE M ET AL: "Adaptive state of charge
algorithm for nickel metal hydride batteries
including hysteresis phenomena", JOURNAL OF
POWER SOURCES, ELSEVIER SA, CH, vol. 126,
no. 1-2, 16 February 2004 (2004-02-16), pages 236
- 249, XP004487901, ISSN: 0378-7753, DOI:
10.1016/J.JPOWSOUR.2003.08.042**
• **XIDONG TANG ET AL: "Capacity estimation for
Li-ion batteries", 2011 AMERICAN CONTROL
CONFERENCE (ACC 2011) : SAN FRANCISCO,
CALIFORNIA, USA, 29 JUNE - 1 JULY 2011, IEEE,
PISCATAWAY, NJ, 29 June 2011 (2011-06-29),
pages 947 - 952, XP032035131, ISBN:
978-1-4577-0080-4**

EP 3 812 777 B1

**(Cont. next page)**

- FLEISCHER CHRISTIAN ET AL: "On-line adaptive battery impedance parameter and state estimation considering physical principles in reduced order equivalent circuit battery models part 2. Parameter and state estimation", JOURNAL OF POWER SOURCES, ELSEVIER SA, CH, vol. 262, 27 March 2014 (2014-03-27), pages 457 - 482, XP029025943, ISSN: 0378-7753, DOI: 10.1016/J.JPOWSOUR.2014.03.046

- GANTENBEIN SOPHIA ET AL: "Impedance based time-domain modeling of lithium-ion batteries: Part I", JOURNAL OF POWER SOURCES, ELSEVIER SA, CH, vol. 379, 17 February 2018 (2018-02-17), pages 317 - 327, XP085350708, ISSN: 0378-7753, DOI: 10.1016/J.JPOWSOUR.2018.01.043

## Description

### TECHNICAL FIELD

This application relates to the field of battery management, and in particular, to a method and apparatus for estimating a state of charge of a battery.

### BACKGROUND

A state of charge (state of charge, SOC) of a battery is one of main parameters of a battery status, and a value of the state of charge is defined as a percentage of a residual capacity of a battery in a total capacity of the battery. For a battery management system (battery management system, BMS), it is difficult to determine the state of charge SOC of the battery due to the following reasons. The state of charge SOC of the battery cannot be directly measured, but can only be indirectly estimated by measuring external parameters such as a current, a voltage, and a temperature, and is affected by a plurality of factors such as a charge/discharge rate of the battery, a temperature, a self-discharge rate, an aging service life, a discharge cutoff voltage of the battery, and an internal resistance. Therefore, it is difficult to accurately estimate the SOC. In addition, the battery is a quite complex electrochemical system, and an internal electrochemical relationship of the battery is a non-linear relationship. Therefore, it is difficult to predict an internal state of the battery by establishing a relationship model by using a detected limited external feature.

In an existing solution, a method and system for estimating a state of charge of a power battery are provided. A Thevenin (Thevenin) equivalent circuit model is selected, pulse current excitation is applied to the power battery, an output voltage and current data of the power battery are collected, and a pulse current excitation response curve is obtained based on a relationship between an output voltage and a time. The excitation response curve is divided into three segments: segments A, B, and C. A time constant is obtained based on the segment A of the excitation response curve with reference to a zero-input response expression of a resistance-capacitance loop and a least square method. Based on the segment B of the excitation response curve with reference to a zero-state response expression of the resistance-capacitance loop, a polarization resistance and a polarization capacitance are obtained by substituting the time constant into the zero-state response expression and by using the least square method. An ohmic internal resistance is obtained based on the segment C of the excitation response curve according to the Ohm's law. An estimated value of the state of charge of the power battery is obtained based on the polarization resistance, the polarization capacitance, and the ohmic internal resistance by using an extended Kalman filtering algorithm.

A response time of each application greatly varies (measured in a level from milliseconds to minutes) with a user use requirement and habit. With time increasing, an ohmic internal resistance, a charge transfer resistance, and a diffusional impedance of a battery sequentially appear and are accumulated to obtain a total internal resistance of the battery. The total internal resistance of the battery also varies with time. In the existing solution, impact of the charge transfer resistance and the diffusional impedance on the total internal resistance of the battery is not considered, and consequently the calculated estimated value of the state of charge of the battery is inaccurate.

EP 2 439 550 A1 discloses a battery state of charge calculation device equipped with an SOCV calculation unit that outputs a first state of charge calculated based on voltage data, an SOCI calculation unit that outputs a second state of charge calculated based on current data, an estimated impedance voltage calculation unit that calculates an impedance voltage value based on the effective state of charge and current data, a static decision unit that determines that the impedance voltage value has remained static for longer than a prescribed time within a range delimited with prescribed threshold values and outputs the decision result, and an SOC determination unit that, based on the decision result, outputs the first state of charge as the effective state of charge when the impedance voltage is static, and otherwise outputs the second state of charge as the effective state of charge.

VERBRUGGE M ET AL: "Adaptive state of charge algorithm for nickel metal hydride batteries including hysteresis phenomena', JOURNAL OF POWER SOURCES, ELSEVIER SA, CH, vol. 126, no. 1-2, 16 February 2004, pages 236-249 discloses a state of charge (SOC)algorithm implemented for a nickel metal hydride (NiMH)battery system. The essential elements of the algorithm were first used as part of the GM Precept hybrid electric vehicle program, which culminated in an 80-mile-per-gallon, 5-passenger, technology-demonstration vehicle. The algorithm is based on a simple equivalent-circuit representation of the battery pack, with the parameters adapted by means of on-line least-square regression. The output of the algorithm is the SOC, which is a measure of the available energy within the battery system, and the powercapability for subsequent charge or discharge, which enablesefficient hybrid vehicle operation through optimal torque allocation. The behavior of the algorithm in terms of convergence, accuracy, and robustnessis examined; for these analyses, the power required from the battery for the Precept to complete a variety of drive schedules provides the power versus time trace. Voltage hysteresis is shown to play a critical role, and this effect makes determining the SOC particularly difficult for NiMH batteries relative to other battery systems (e.g., lead acid and lithium ion).

# EP 3 812 777 B1

## SUMMARY

The invention provides a method and apparatus for estimating a state of charge of a battery as defined in the independent claims, to estimate a state of charge of a battery according to a battery internal resistance model with higher accuracy, thereby improving accuracy of an estimated value of the state of charge of the battery.

A first aspect of this application provides a method for estimating a state of charge of a battery. The method includes: obtaining, at a preconfigured time interval, a current-moment charge/discharge current, a current-moment temperature, a current-moment coulomb capacity, and a previous-moment state of charge value of a to-be-measured battery in real time, where the preconfigured time interval is duration between a previous moment and a current moment, and the preconfigured time interval is preconfigured; obtaining discharge duration of the to-be-measured battery, where the discharge duration is duration of a charge/discharge current; determining a current-moment internal resistance response type of the to-be-measured battery based on the discharge duration; determining current-moment internal resistance data of the to-be-measured battery based on the current-moment internal resistance response type, the current-moment temperature, the current-moment charge/discharge current, and the previous-moment state of charge value; determining a current-moment unusable capacity of the to-be-measured battery based on the current-moment internal resistance data, the current-moment charge/discharge current, and the current-moment temperature, where the unusable capacity is a state of charge value when the to-be-measured battery cannot release a capacity; and determining a current-moment state of charge value of the to-be-measured battery based on the current-moment coulomb capacity and the current-moment unusable capacity. A more accurate battery internal resistance model is established based on impact of a temperature, an SOC, a current, and discharge duration on a resistance of a battery. Accurate internal resistance data of the to-be-measured battery is obtained based on an internal resistance response type of the to-be-measured battery and the more accurate battery internal resistance model. Then, an unusable capacity of the battery is calculated based on the internal resistance data, so that a current state of charge of the battery is accurately estimated.

In a possible design, in a first implementation of the first aspect of the embodiments of this application, the determining a current-moment internal resistance response type of the to-be-measured battery based on the discharge duration includes: determining the current-moment internal resistance response type of the to-be-measured battery based on the discharge duration and a preconfigured first correspondence, where the first correspondence is used to indicate a correspondence between the discharge duration of the to-be-measured battery and the internal resistance response type of the to-be-measured battery. The process of determining the corresponding internal resistance response type based on the correspondence between the discharge duration of the to-be-measured battery and the internal resistance response type of the to-be-measured battery and based on a current-moment discharge duration is refined, thereby increasing the implementation of this application.

In a possible design, in a first implementation of the first aspect of the embodiments of this application, the first correspondence includes: when the discharge duration is less than or equal to a first threshold, the internal resistance response type is a first response type, and the first response type includes an ohmic resistance; when the discharge duration is greater than a first threshold and less than or equal to a second threshold, the internal resistance response type is a second response type, and the second response type includes an ohmic resistance and a charge transfer resistance; or when the discharge duration is greater than a second threshold, the internal resistance response type is a third response type, and the third response type includes an ohmic resistance, a charge transfer resistance, and a diffusional impedance. The relationship between the discharge duration and the internal resistance response type is refined, and a correspondence between a length of the discharge duration and the internal resistance response type is specified.

In a possible design, in a second implementation of the first aspect of the embodiments of this application, the determining current-moment internal resistance data of the to-be-measured battery based on the current-moment internal resistance response type, the current-moment temperature, the current-moment charge/discharge current, and the previous-moment state of charge value includes: determining a second correspondence based on the first response type, where the second correspondence is used to indicate a correspondence between the ohmic resistance of the to-be-measured battery, and a temperature and a state of charge value that are of the to-be-measured battery; and determining the current-moment internal resistance data of the to-be-measured battery based on the second correspondence, the current-moment temperature, the current-moment charge/discharge current, and the previous-moment state of charge value, where the internal resistance data is a current-moment ohmic resistance. The process of determining the current-moment ohmic resistance of the to-be-measured battery is refined, thereby increasing the implementation of this application.

In a possible design, in a third implementation of the first aspect of the embodiments of this application, the determining current-moment internal resistance data of the to-be-measured battery based on the current-moment internal resistance response type, the current-moment temperature, the current-moment charge/discharge current, and the previous-moment state of charge value includes: determining a second correspondence and a third correspondence based on the second response type, where the second correspondence is used to indicate a correspondence between the ohmic resistance of the to-be-measured battery, and a temperature and a state of charge value that are of the to-be-measured battery, and the third correspondence is used to indicate a correspondence between the charge transfer resistance of the to-be-measured battery, and the temperature, the state of charge, and the charge/discharge current that are of the to-be-measured battery; and determining the current-moment internal resistance data of the to-be-measured battery based on the second correspondence, the third correspondence, the current-moment temperature, the current-moment charge/discharge current, and the previous-moment state of charge value, where the internal resistance data is a sum of a current-moment ohmic resistance and a current-moment charge transfer resistance. The process of determining the current-moment ohmic resistance and the current-moment charge transfer resistance of the to-be-measured battery is refined, thereby increasing the implementation of this application.

In a possible design, in a fourth implementation of the first aspect of the embodiments of this application, the determining current-moment internal resistance data of the to-be-measured battery based on the current-moment internal resistance response type, the current-moment temperature, the current-moment charge/discharge current, and the previous-moment state of charge value includes: determining a second correspondence, a third correspondence, and a fourth correspondence based on the third response type, where the second correspondence is used to indicate a correspondence between the ohmic resistance of the to-be-measured battery, and a temperature and a state of charge value that are of the to-be-measured battery, the third correspondence is used to indicate a correspondence between the charge transfer resistance of the to-be-measured battery, and the temperature, the state of charge, and the charge/-discharge current that are of the to-be-measured battery, and the fourth correspondence is used to indicate a correspondence between the diffusional impedance of the to-be-measured battery, and the temperature, the state of charge value, and the charge/discharge current that are of the to-be-measured battery; and determining the current-moment internal resistance data of the to-be-measured battery based on the second correspondence, the third correspondence, the fourth correspondence, the current-moment temperature, the current-moment charge/discharge current, and the previous-moment state of charge value, where the internal resistance data is a sum of a current-moment ohmic resistance, a current-moment charge transfer resistance, and a current-moment diffusional impedance. The process of determining the current-moment ohmic resistance, the current-moment charge transfer resistance, and the current-moment diffusional impedance of the to-be-measured battery is refined, thereby increasing the implementation of this application.

According to the first aspect of this application, the determining a current-moment unusable capacity of the to-be-measured battery based on the current-moment internal resistance data, the current-moment charge/discharge current, and the current-moment temperature includes: determining a current-moment internal resistance voltage of the to-be-measured battery based on the current-moment internal resistance data and the current-moment charge/discharge current, where the internal resistance voltage is a voltage loss caused by an internal resistance of the to-be-measured battery; determining a current-moment unusable voltage of the to-be-measured battery based on the current-moment internal resistance voltage and a preconfigured cutoff voltage; and determining the current-moment unusable capacity of the to-be-measured battery based on the current-moment unusable voltage, the current-moment temperature, and a preconfigured fifth correspondence, where the fifth correspondence is used to indicate a correspondence between an open-circuit voltage of the to-be-measured battery, and the temperature and the state of charge value that are of the to-be-measured battery.

In a possible design, in a fifth implementation of the first aspect of the embodiments of this application, the determining a current-moment state of charge value of the to-be-measured battery based on the current-moment coulomb capacity and the current-moment unusable capacity includes: determining an initial capacity based on a preconfigured full charge capacity, the previous-moment state of charge value, and the fifth correspondence, where the initial capacity is a previous-moment capacity of the to-be-measured battery; determining a current-moment residual capacity of the to-be-measured battery based on the initial capacity, the current-moment coulomb capacity, and the current-moment unusable capacity; and determining the current-moment state of charge value of the to-be-measured battery based on the current-moment residual capacity, the preconfigured full charge capacity, and the current-moment unusable capacity. The process of estimating the state of charge value is described in detail, making the process of estimating the state of charge easier to implement.

A third aspect of this application provides an apparatus for estimating a state of charge of a battery. The estimation apparatus includes: a first obtaining unit, configured to obtain, at a preconfigured time interval, a current-moment charge/discharge current, a current-moment temperature, a current-moment coulomb capacity, and a previous-moment state of charge value of a to-be-measured battery in real time, where the preconfigured time interval is duration between a previous moment and a current moment; a second obtaining unit, configured to obtain discharge duration of the to-be-measured battery, where the discharge duration is duration of a charge/discharge current; a first determining unit, configured to determine a current-moment internal resistance response type of the to-be-measured battery based on the discharge duration; a second determining unit, configured to determine current-moment internal resistance data of the to-be-measured battery based on the current-moment internal resistance response type, the current-moment temperature, the current-moment charge/discharge current, and the previous-moment state of charge value; a third determining unit, configured to determine a current-moment unusable capacity of the to-be-measured battery based on the current-moment internal resistance data, the current-moment charge/discharge current, and the current-moment temperature, where the unusable capacity is a state of charge value when the to-be-measured battery cannot release a capacity; and a fourth determining unit, configured to determine a current-moment state of charge value of the to-be-measured battery based on the current-moment coulomb capacity and the current-moment unusable capacity. A more accurate battery internal resistance model is established based on impact of a temperature, an SOC, a current, and discharge duration on a resistance of a battery. Accurate internal resistance data of the to-be-measured battery is obtained based on an internal resistance response type of the to-be-measured battery and the more accurate battery internal resistance model. Then, an unusable capacity of the battery is calculated based on the internal resistance data, so that a current state of charge of the battery is accurately estimated.

In the second aspect of the embodiments of this application, the first determining unit is specifically configured to: determine the current-moment internal resistance response type of the to-be-measured battery based on the discharge duration and a preconfigured first correspondence, where the first correspondence is used to indicate a correspondence between the discharge duration of the to-be-measured battery and the internal resistance response type of the to-be-measured battery. The process of determining a corresponding internal resistance response based on the correspondence between the discharge duration of the to-be-measured battery and the internal resistance response type of the to-be-measured battery and based on a current-moment discharge duration is refined, thereby increasing the implementation of this application.

In a possible design, in a first implementation of the second aspect of the embodiments of this application, the first correspondence includes: when the discharge duration is less than or equal to a first threshold, the internal resistance response type is a first response type, and the first response type includes an ohmic resistance; when the discharge duration is greater than a first threshold and less than or equal to a second threshold, the internal resistance response type is a second response type, and the second response type includes an ohmic resistance and a charge transfer resistance; or when the discharge duration is greater than a second threshold, the internal resistance response type is a third response type, and the third response type includes an ohmic resistance, a charge transfer resistance, and a diffusional impedance. The relationship between the discharge duration and the internal resistance response type is refined, and a correspondence between a length of the discharge duration and the internal resistance response type is specified.

In a possible design, in a second implementation of the second aspect of the embodiments of this application, the second determining unit is specifically configured to: determine a second correspondence based on the first response type, where the second correspondence is used to indicate a correspondence between the ohmic resistance of the to-be-measured battery, and a temperature and a state of charge value that are of the to-be-measured battery, and determine the current-moment internal resistance data of the to-be-measured battery based on the second correspondence, the current-moment temperature, the current-moment charge/discharge current, and the previous-moment state of charge value, where the internal resistance data is a current-moment ohmic resistance; or determine a second correspondence and a third correspondence based on the second response type, where the second correspondence is used to indicate a correspondence between the ohmic resistance of the to-be-measured battery, and a temperature and a state of charge value that are of the to-be-measured battery, and the third correspondence is used to indicate a correspondence between the charge transfer resistance of the to-be-measured battery, and the temperature, the state of charge, and the charge/discharge current that are of the to-be-measured battery, and determine the current-moment internal resistance data of the to-be-measured battery based on the second correspondence, the third correspondence, the current-moment temperature, the current-moment charge/discharge current, and the previous-moment state of charge value, where the internal resistance data is a sum of a current-moment ohmic resistance and a current-moment charge transfer resistance; or determine a second correspondence, a third correspondence, and a fourth correspondence based on the third response type, where the second correspondence is used to indicate a correspondence between the ohmic resistance of the to-be-measured battery, and a temperature and a state of charge value that are of the to-be-measured battery, the third correspondence is used to indicate a correspondence between the charge transfer resistance of the to-be-measured battery, and the temperature, the state of charge, and the charge/discharge current that are of the to-be-measured battery, and the fourth correspondence is used to indicate a correspondence between the diffusional impedance of the to-be-measured battery, and the temperature, the state of charge value, and the charge/discharge current that are of the to-be-measured battery, and determine the current-moment internal resistance data of the to-be-measured battery based on the second correspondence, the third correspondence, the fourth correspondence, the current-moment temperature, the current-moment charge/discharge current, and the previous-moment state of charge value, where the internal resistance data is a sum of a current-moment ohmic resistance, a current-moment charge transfer resistance, and a current-moment diffusional impedance. The process of determining the current-moment ohmic resistance, the current-moment charge transfer resistance, and the current-moment diffusional impedance of the to-be-measured battery is refined, thereby increasing the implementation of this application.

According to the second aspect of this application, the third determining unit is specifically configured to: determine a current-moment internal resistance voltage of the to-be-measured battery based on the current-moment internal resistance data and the current-moment charge/discharge current, where the internal resistance voltage is a voltage loss caused by an internal resistance of the to-be-measured battery; determine a current-moment unusable voltage of the to-be-measured battery based on the current-moment internal resistance voltage and a preconfigured cutoff voltage; and determine the current-moment unusable capacity of the to-be-measured battery based on the current-moment unusable voltage, the current-moment temperature, and a preconfigured fifth correspondence, where the fifth correspondence is used to indicate a correspondence between an open-circuit voltage of the to-be-measured battery, and the temperature and the state of charge value that are of the to-be-measured battery.

In a possible design, in a third implementation of the second aspect of the embodiments of this application, the fourth determining unit is specifically configured to: determine an initial capacity based on a preconfigured full charge capacity, the previous-moment state of charge value, and the fifth correspondence, where the initial capacity is a previous-moment capacity of the to-be-measured battery; determine a current-moment residual capacity of the to-be-measured battery based on the initial capacity, the current-moment coulomb capacity, and the current-moment unusable capacity; and determine the current-moment state of charge value of the to-be-measured battery based on the current-moment residual capacity, the preconfigured full charge capacity, and the current-moment unusable capacity. The process of estimating a state of charge is described in detail, making the process of estimating the state of charge easier to implement.

A third aspect of this application provides a terminal, including:

a battery, and an apparatus for estimating a state of charge of a battery, where
the apparatus for estimating a state of charge of a battery is the apparatus for estimating a state of charge of a battery according to any one of the second aspect and the implementations of the second aspect.

A fourth aspect of this application provides a computer program product including an instruction. When the computer program product is run on a computer, the computer is enabled to perform the method in the foregoing aspects.

## BRIEF DESCRIPTION OF DRAWINGS

FIG. 1A is a schematic diagram of impact of a temperature of a battery on a resistance of the battery;
FIG. 1B is a schematic diagram of impact of a state of charge of a battery and a current on a resistance of the battery;
FIG. 1C is a schematic diagram of impact of discharge duration on a resistance of a battery;
FIG. 2 is a schematic diagram of an embodiment of a method for estimating a state of charge of a battery according to an embodiment of this application;
FIG. 3 is a schematic diagram of a second-order equivalent circuit according to an embodiment of this application;
FIG. 4 is a schematic diagram of a third-order equivalent circuit according to an embodiment of this application;
FIG. 5 is a schematic diagram of an embodiment of an apparatus for estimating a state of charge of a battery according to an embodiment of this application; and
FIG. 6 is another schematic diagram of an embodiment of a method for estimating a state of charge of a battery according to an embodiment of this application.

## DESCRIPTION OF EMBODIMENTS

Embodiments of this application provide a method and an apparatus for estimating a state of charge of a battery, to estimate a state of charge of a battery according to a battery internal resistance model with higher accuracy. This improves accuracy of an estimated value of the state of charge of the battery.

To make a person skilled in the art understand the technical solutions in this application better, the following describes the embodiments of this application with reference to the accompanying drawings in the embodiments of this application.

In this application, the terms "first", "second", and the like are intended to distinguish between similar objects but do not necessarily indicate a specific order or sequence. Moreover, the terms "include", "have" and any other variants in this application mean to cover the non-exclusive inclusion, for example, a process, method, system, product, or device that includes a list of steps or units is not necessarily limited to those units, but may include other units not expressly listed or inherent to such a process, method, system, product, or device.

In an existing solution, a method for measuring an internal resistance of a battery is provided. Discharge performance tests of a first battery are conducted at various ambient temperatures to obtain current values and voltage values that are corresponding to different states of charge. In different states of charge, corresponding current values and voltage values are calculated according to a battery equivalent circuit model, to obtain direct current internal resistances corresponding to the different states of charge. Polynomial fitting is performed based on the direct current internal resistances corresponding to the different states of charge at the various ambient temperatures, to establish a mathematical model for estimating the direct current internal resistance. The mathematical model indicates a relationship between a direct current internal resistance, a state of charge, and a temperature. When an ambient temperature and a state of charge of the second battery are known, a direct current internal resistance of a second battery is estimated by using the mathematical model. Therefore, the mathematical model for estimating the direct current internal resistance is established, to estimate a direct current resistance based on a temperature and a state of charge of a battery. This improves accuracy of estimating the direct current internal resistance of the battery.

It may be understood that an internal resistance of a battery is affected by a plurality of factors in the following:

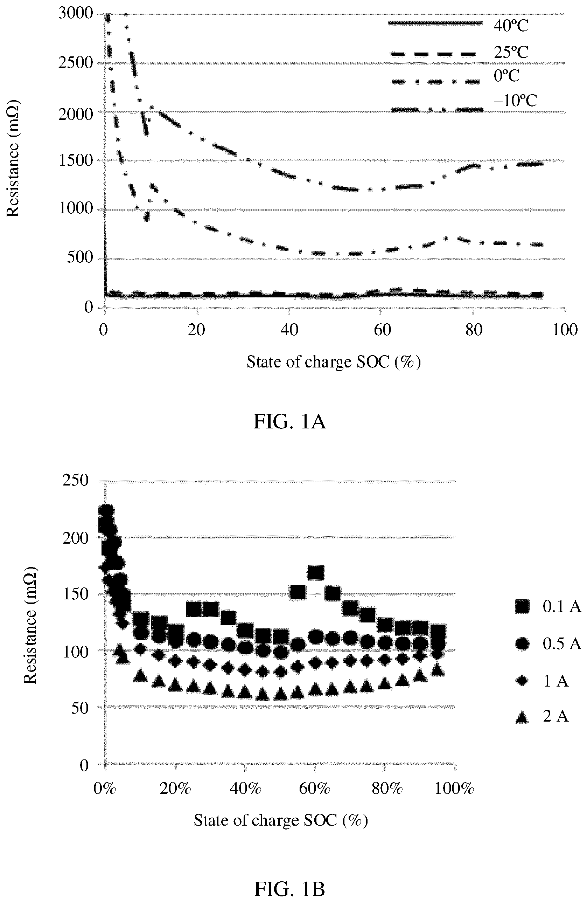

1. The internal resistance of the battery gradually increases with temperature decreasing. Especially in a low temperature environment, the internal resistance of the battery increases dramatically, as shown in FIG. 1A.

2. Within a range from 10% of an SOC to 100% of the SOC, the internal resistance of the battery fluctuates slightly. However, when the SOC decreases to a value below 10% of the SOC, the internal resistance of the battery increases dramatically, as shown in FIG. 1B.

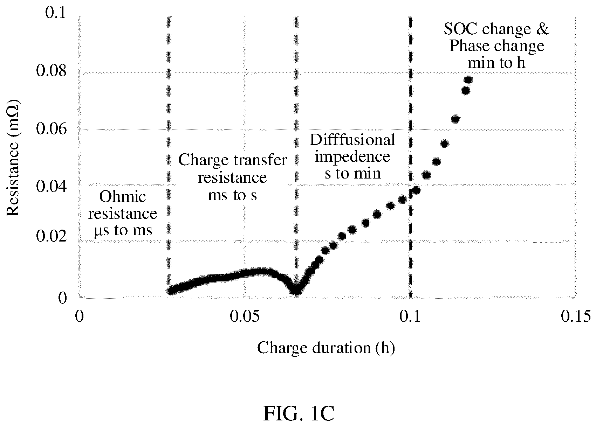

3. A response time of each application greatly varies (in a level from ms to min) with a user use requirement and habit. With time increasing, an ohmic internal resistance, a charge transfer resistance, and a diffusional impedance of the battery sequentially appear and are accumulated to obtain a total internal resistance of the battery. The total internal resistance of the battery also varies with time, as shown in FIG. 1C.

4. As there are various applications on a mobile terminal product, different applications have different peak currents and average currents when the applications are run. Generally, the internal resistance of the battery decreases with current increasing, as shown in FIG. 1B.

How to accurately obtain the internal resistance of the battery is crucial to accurately estimating a state of charge (state of charge, SOC) of the battery. In the existing solution, by considering only two factors: a temperature and a state of charge, a two-dimensional data table for an internal capacitance and a temperature and an SOC is established. However, impact of factors such as a current and a time on the internal resistance of the battery is not considered, and consequently an estimated state of charge value of the battery is inaccurate. Therefore, this application provides a method and an apparatus for estimating a state of charge of a battery, to estimate a state of charge of a battery according to a battery internal resistance model with higher accuracy. This improves accuracy of the estimated state of charge value of the battery. It should be noted that, in the battery internal resistance model, impact of factors such as a temperature, a state of charge, a current, and a time on the internal resistance of the battery is considered. Therefore, the obtained internal resistance of the battery is more accurate, and a more accurate state of charge value is obtained through estimation.

For ease of description, in the embodiments of this application, a lithium battery is used as an example for description. The solutions of this application may also be applied to a battery of another type, including but not limited to the lithium battery. For example, the solutions of this application may also be applied to a lithium metal-air battery, a lead-acid battery, a nickel-metal hydride battery, a nickel-cadmium battery, or the like. This is not specifically limited herein.

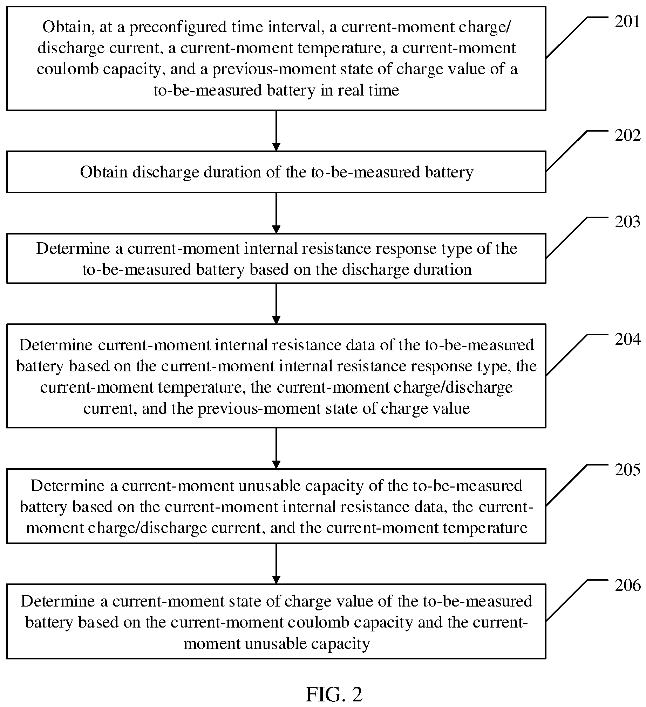

For ease of understanding, the following describes a specific procedure in the embodiments of this application. Referring to FIG. 2, an embodiment of a method for estimating a state of charge of a battery according to an embodiment of this application includes the following steps.

201. Obtain, at a preconfigured time interval, a current-moment charge/discharge current, a current-moment temperature, a current-moment coulomb capacity, and a previous-moment state of charge value of a to-be-measured battery in real time.

An apparatus for estimating a state of charge of a battery obtains, at the preconfigured time interval, the current-moment charge/discharge current, the current-moment temperature, the current-moment coulomb capacity, and the previous-moment state of charge value of the to-be-measured battery in real time. The preconfigured time interval is duration between a previous moment and a current moment. The coulomb capacity is total consumed capacities of the to-be-measured battery from the previous moment to the current moment.

Specifically, the apparatus for estimating a state of charge of a battery obtains current-moment status information of the to-be-measured battery every three seconds. The status information includes the current-moment charge/-discharge current, the current-moment temperature, and the current-moment coulomb capacity of the to-be-measured battery. For example, the apparatus for estimating a state of charge of a battery starts timing from the 0th second. When a recorded time is the 3rd second, the apparatus for estimating a state of charge of a battery obtains a charge/discharge current, a temperature, and a coulomb capacity of the to-be-measured battery connected to the apparatus for estimating a state of charge of a battery. When a recorded time is the 6th second, the apparatus for estimating a state of charge of a battery obtains a charge/discharge current, a temperature, and a coulomb capacity of the to-be-measured battery again. The apparatus for estimating a state of charge of a battery obtains the previous-moment state of charge value. For example, if the current moment is the 6th second, the apparatus for estimating a state of charge of a battery obtains a state of charge value of the to-be-measured battery at the 3rd second. The state of charge value is preconfigured and stored in the apparatus for estimating a state of charge of a battery.

It may be understood that status information of the to-be-measured battery at different moments is not completely the same. For example, when a time is a second 3, the charge/discharge current of the to-be-measured battery may be 0.1 A, the temperature is 40°C, and the coulomb capacity is 0.3 C. When a time is a second 6, the charge/discharge current of the to-be-measured battery may be 0.1 A, the temperature is 40°C, and the coulomb capacity is 0.6 C.

It should be noted that the apparatus for estimating a state of charge of a battery may set the time interval based on an actual requirement. For example, the time interval may be two seconds, four seconds, eight seconds, or the like, or may be one minute, five minutes, or the like. This is not specifically limited herein.

202. Obtain discharge duration of the to-be-measured battery.

The apparatus for estimating a state of charge of a battery obtains the discharge duration of the to-be-measured battery, and the discharge duration is duration, from a start moment to the current moment, in which the to-be-measured battery continuously discharges.

Each time interval is a detection period, and the discharge duration may be duration of a charge/discharge current that is longer than the detection period, or the discharge duration may be duration of a charge/discharge current that is shorter than the detection period. There is no association relationship between the discharge duration and the detection period. Duration from a moment at which discharge starts to the current moment is used as the discharge duration. The charge/discharge current may be an average current or a peak current. Discharge duration varies with an application scenario. For example, when a terminal to which the to-be-measured battery belongs is in a power-on scenario, the peak current is 3000 milliamperes, duration of the peak current is 800 milliseconds, the average current is 1500 milliamperes, and duration of the average current is 20000 milliseconds. If the average current is used as the charge/discharge current, the discharge duration is 20000 milliseconds; or if the peak current is used as the charge/discharge current, the discharge duration is 800 milliseconds. When the terminal to which the to-be-measured battery belongs is in a power-off scenario, the peak current is 1500 milliamperes, and duration of the peak current is 200 milliseconds, the average current is 600 milliamperes, and duration of the average current is 5200 milliseconds. If the average current is used as the charge/-discharge current, the discharge duration is 5200 milliseconds; or if the peak current is used as the charge/discharge current, the discharge duration is 200 milliseconds.

It should be noted that the peak current or the average current is selected as the charge/discharge current based on the specified time interval. For example, when the preconfigured time interval is three seconds, the peak current is used as the charge/discharge current, and duration of the peak current in different application scenarios is within three seconds. When the preconfigured time interval is 60 seconds, the average current is used as the charge/discharge current, and duration of the average current in different application scenarios is within 60 seconds. In this way, different application scenarios are distinguished between each other based on the discharge duration.

203. Determine a current-moment internal resistance response type of the to-be-measured battery based on the discharge duration.

The apparatus for estimating a state of charge of a battery determines the current-moment internal resistance response type of the to-be-measured battery based on the discharge duration. Specifically, the apparatus for estimating a state of charge of a battery determines the current-moment internal resistance response type of the to-be-measured battery based on the discharge duration and a preconfigured first correspondence. The first correspondence is used to indicate a correspondence between the discharge duration of the to-be-measured battery and the internal resistance response type of the to-be-measured battery.

It should be noted that the current-moment internal resistance response type of the to-be-measured battery is determined based on the discharge duration. When the discharge duration is measured in milliseconds, the internal resistance response type of the to-be-measured battery is a first response type, and the first response type includes an ohmic resistance. When the discharge duration is measured in seconds, the internal resistance response type of the to-be-measured battery is a second response type, and the second response type includes an ohmic resistance and a charge transfer resistance. When the discharge duration is measured in minutes, the internal resistance response type of the to-be-measured battery is a third response type, and the third response type includes an ohmic resistance, a charge transfer resistance, and a diffusional impedance. As the discharge duration increases, a resistance of the to-be-measured battery also increases. A person skilled in the art may obtain the correspondence according to common knowledge in the art. Details are not described herein.

For example, in a product test, peak current values and average current values in application scenarios, and duration in the scenarios are listed in Table 1. An example in which the average current is used as the charge/discharge current is used for description. When an operation such as taking photos in standard mode or sliding on the home screen is performed, and when discharge duration of the average current is less than or equal to a first threshold, the first threshold may be 1000 milliseconds, that is, when the duration of the average current is from 1 millisecond to 1000 milliseconds, there is only an ohmic resistance response, and the internal resistance response type of the to-be-measured battery is the ohmic resistance response. When an operation such as exiting from a standby state to enter the home screen or powering off is performed, and when discharge duration of the average current is greater than a first threshold and less than or equal to a second threshold, the second threshold is 10000 milliseconds, that is, when the duration of the average current is from 1000 milliseconds to 10000 milliseconds, there is still a charge transfer resistance response after an ohmic resistance response in the to-be-measured battery, and the internal resistance response type of the to-be-measured battery is the ohmic resistance response and the charge transfer resistance response. When an operation such as answering a call, browsing a web page, playing back a local video, playing game at a maximum loudspeaker volume, performing navigation at a maximum loudspeaker volume, and powering on is performed, the duration of the average current of the to-be-measured battery is greater than a second threshold, that is, when the duration of the average current is at least 10000 milliseconds, in addition to an ohmic resistance response and a charge transfer resistance response, there is still a diffusional impedance response. Therefore, it is determined that the internal resistance response type is an ohmic resistance response, a charge transfer resistance response, and a diffusional impedance response. It may be understood that there may be other application scenarios, which are corresponding to different peak currents and average currents, different duration of the peak currents, and different duration of the average currents. In addition, the first threshold and the second threshold may be set according to an actual case. Details are not described herein.

**Table 1**

| Application scenarios | Peak current/mA | Duration/ms | Average current/mA | Duration/ms |
|---|---|---|---|---|
| Powering on | 3000 | 800 | 1500 | 20000 |
| Powering off | 1500 | 200 | 600 | 5200 |
| Exiting from a standby state to enter the home screen | 1400 | 150 | 600 | 2500 |
| Sliding on the home screen | 660 | 25 | 420 | 520 |
| Answering a call | 2000 | 350 | 520 | 30000 |
| Browsing a web page | 1600 | 900 | 520 | 50000 |
| Taking photos in a standard mode | 4000 | 3 | 2400 | 10 |
| Playing back a local video | 1400 | 260 | 520 | 33000 |
| Playing game at a maximum loudspeaker volume | 2600 | 350 | 840 | 30000 |
| Performing navigation at a maximum loudspeaker volume | 2200 | 100 | 640 | 240000 |

It should be noted that, before the internal resistance response type is determined, a total internal resistance of the battery needs to be obtained based on an initial relationship table between a temperature of the battery, a state of charge of the battery, and a charge/discharge current of the battery, and the total internal resistance is further divided into an ohmic resistance and a polarization resistance (that is, the charge transfer resistance and the diffusional impedance) based on different time constants by using an equivalent circuit model method, to obtain an ohmic resistance model and a polarization resistance model (that is, a charge transfer resistance model and a diffusional impedance model). In this application, a model of the to-be-measured battery that needs to be invoked at the current moment is determined according to the ohmic resistance model, the charge transfer resistance model, and the diffusional impedance model.

The following describes processes of obtaining the ohmic resistance model and the polarization resistance model (the charge transfer resistance model and the diffusional impedance model).

1. The process of obtaining the ohmic resistance model is as follows:

A selected battery is tested by using an open-circuit voltage method. Specific test steps are as follows:

(1) Fully charge the battery in a constant-current and constant-voltage charge mode, rest the battery for a period of time for voltage stabilization, and read a voltage $V_0$ at this time (for example, 100% of an SOC).
(2) Discharge the battery to a fixed state of charge (for example, 95% of the SOC) by a constant current $I_1$, read a voltage $V_1$ corresponding to a moment when discharge starts (for example, when the discharge duration is 0.1s), read a voltage $V_2$ corresponding to a moment when discharge ends, and rest the battery for a period of time for voltage stabilization.
(3) Repeat step (2) until the SOC of the battery drops to 0%.
(4) Change a test temperature and a charge current of the battery, to conduct a test according to steps (1) to (3), to obtain ohmic internal resistances at different temperatures, with different currents, and in different SOC conditions.

The ohmic internal resistance is calculated according to the following formula:

$$R_0 = (V_0 - V_1)/I_1,$$

where $R_0$ represents an ohmic internal resistance, $V_0$ represents a before-charge voltage of the battery, $V_1$ is a voltage of the battery when charge starts, and $I_1$ represents the discharge current.

An obvious voltage drop generated at the moment when charge starts is caused by the ohmic internal resistance. In addition, the ohmic internal resistance $R_0$ does not vary with the discharge current, and the ohmic resistance model may be obtained by changing a temperature T of the battery and the state of charge SOC of the battery. For example, a relationship table between the ohmic internal resistance, the temperature T of the battery, and the state of charge SOC of the battery may be obtained, as listed in Table 2.

**Table 2**

| State of charge SOC | Temperature T | | | | |
|---|---|---|---|---|---|
| | 60°C | 40°C | 25°C | ... | -20°C |
| 95% | 54.8 mΩ | 41.5 mΩ | 81.3 mΩ | ... | 608.4 mΩ |
| 90% | 55.3 mΩ | 41.3 mΩ | 81.4 mΩ | ... | 592.7 mΩ |
| ... | ... | ... | ... | ... | ... |
| 10% | 59.6 mΩ | 44.1 mΩ | 84.6 mΩ | ... | 573.8 mΩ |
| 5% | ... | ... | ... | ... | ... |
| 0% | ... | ... | ... | ... | ... |

2. The process of obtaining the polarization resistance model is as follows:

Step 1: Test a selected target battery by using an open-circuit voltage method. Specific test steps are as follows:

(1) Fully charge the target battery in a constant-current and constant-voltage charge mode, rest the target battery for a period of time for voltage stabilization, and read a voltage $V_0$ at this time (for example, 100% of an SOC).
(2) Discharge the target battery to a fixed state of charge (for example, 95% of the SOC) by a constant current $I_1$, read a voltage $V_1$ corresponding to a moment when discharge starts (for example, when the discharge duration is 0.1s), read a voltage $V_2$ corresponding to a moment when discharge ends, and rest the target battery for a period of time for voltage stabilization.
(3) Repeat step (2) until the SOC of the target battery drops to 0%.
(4) Change a test temperature and a charge current of the target battery, to conduct a test according to steps (1) to (3), to obtain polarization internal resistances at different temperatures, with different currents, and in different SOC conditions.

The polarization internal resistance is calculated according to the following formula:

$$R_p = (V_0 - V_2)/I_1,$$

where $R_0$ represents the polarization internal resistance, $V_0$ represents a before-charge voltage of the target battery, $V_2$ represents a voltage of the target battery when charge starts, and $I_1$ represents the discharge current.

A total polarization internal resistance of the battery is affected by a temperature of the battery, a state of charge SOC of the battery, and a charge current. The polarization resistance model may be obtained by changing the temperature T (-30 to 60°C) of the battery, the state of charge SOC (0 to 100%) of the battery, and the charge/discharge current I (0.01 A to 5 A). For example, a relationship table between the polarization internal resistance, the temperature T of the battery, the state of charge SOC of the battery, and the charge/discharge current I may be obtained, as listed in Table 3.

**Table 3**

| State of charge SOC | Current I | Temperature T | | | | |
|---|---|---|---|---|---|---|
| | | 60°C | 40°C | 25°C | ... | -20°C |
| 95% | 0.01 A | 107.7 mΩ | 72.5 mΩ | 116.8 mΩ | ... | 3370.3 mΩ |
| | 0.1 A | 78.8 mΩ | 100.5 mΩ | 116.9 mΩ | ... | 2086.5 mΩ |
| | 0.5 A | 59.0 mΩ | 72.3 mΩ | 106.7 mΩ | ... | 648.0 mΩ |
| | 1 A | 54.7 mΩ | 67.1 mΩ | 96.5 mΩ | ... | - |
| | ... | ... | ... | ... | ... | ... |
| | 5 A | 48.0 mΩ | 57.9 mΩ | 76.6 mΩ | ... | - |
| ... | | | | | | |
| 10% | 0.01 A | 54.8 mΩ | 80.2 mΩ | 142.7 mΩ | ... | 3752.1 mΩ |
| | 0.1 A | 49.6 mΩ | 98.4 mΩ | 128.6 mΩ | ... | - |
| | 0.5 A | 53.4 mΩ | 72.8 mΩ | 116.4 mΩ | ... | - |
| | 1 A | 58.4 mΩ | 73.7 mΩ | 101.5 mΩ | ... | - |
| | ... | ... | ... | ... | ... | ... |
| | 5 A | 57.4 mΩ | 65.6 mΩ | 81.1 mΩ | ... | - |
| ... | | | | | | |

Step 2: Based on different time responses of battery discharge types, the total polarization internal resistance $R_p$ of the battery is further divided into a charge transfer resistance and a diffusional impedance, that is, the polarization internal resistance model is divided into the charge transfer resistance model and the diffusional impedance model. For example, a relationship table between the battery charge transfer resistance or the battery diffusional impedance, and the temperature of the battery, the state of charge SOC of the battery, and the charge/discharge current may be established.

(1) Determine a sub-type of the polarization internal resistance based on the discharge duration.
A relationship between a time response, and the ohmic internal resistance, the charge transfer resistance, and the diffusional impedance is as follows: The ohmic resistance is measured in a level from microseconds to milliseconds (μs to ms), the charge transfer resistance is measured in a level from milliseconds to seconds (ms to s), and the diffusional impedance is measured in a level from seconds to minutes (s to min).
(2) Divide the polarization internal resistance according to an equivalent circuit model by using a least square fitting method or a Kalman filtering algorithm.

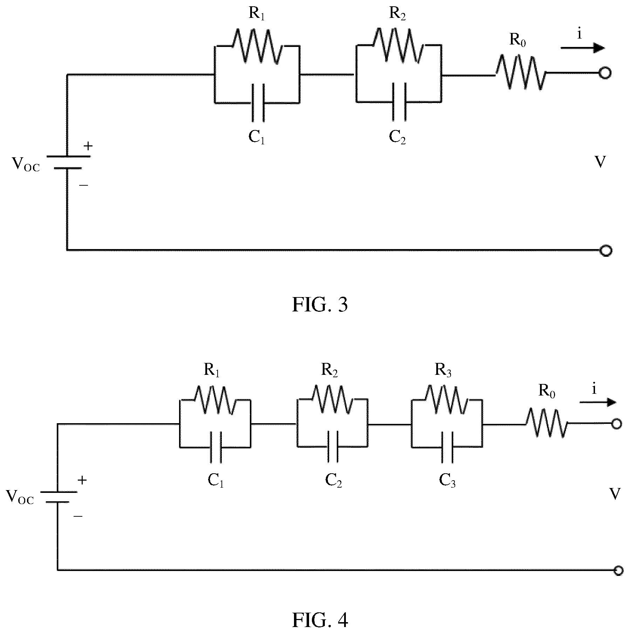

The equivalent circuit model of the battery may be a second-order equivalent circuit model, and a structure is shown in FIG. 3. $R_0$ represents an ohmic resistance, $R_1$ and $C_1$, and $R_2$ and $C_2$ represent polarization effects of the battery, and $R_1$ and $R_2$ are respectively corresponding to a charge transfer resistance and a diffusional impedance.
When the second-order equivalent circuit model is divided by using the least square fitting method, a method for calculating the charge transfer resistance and the diffusional impedance is as follows:
When the lithium-ion battery is in a discharge state, a voltage output of the lithium-ion battery is:

$$V = V_{oc} - IR_0 - IR_1(1 - e^{-\frac{t}{\tau_1}}) - IR_2(1 - e^{-\frac{t}{\tau_2}}) \qquad (1)$$

A selected fitting curve expression is as follows:

$$V = k_0 + k_1 e^{-\lambda_1 \cdot t} + k_2 e^{-\lambda_2 \cdot t} \qquad (2)$$

Fitting is performed on parameters in software by using the least square fitting method, to obtain parameters $k_0$,

$k_1$, $k_2$, $\lambda_1$, and $\lambda_2$ in Formula (2).

It can be learned from Formula (1) and Formula (2) that,

$$R_1 = \frac{k_1}{I}, \quad R_2 = \frac{k_2}{I} \tag{3}$$

$$C_1 = \frac{1}{\lambda_1 R_1}, \quad C_2 = \frac{1}{\lambda_2 R_2} \tag{4}$$

Values of parameters $R_1$, $R_2$, $C_1$, and $C_2$ may be obtained according to Formula (3) and Formula (4), where $R_1$ represents the charge transfer resistance and $R_2$ represents the diffusional impedance.

When the second-order equivalent circuit model is divided by using the Kalman filtering algorithm, a method for calculating the charge transfer resistance and the diffusional impedance is as follows:

For a second-order RC equivalent circuit model, an equation for a state of the battery is as follows:

$$\begin{cases} SOC' = -\dfrac{\eta I}{3600Q} \\[2ex] V_1' = -\dfrac{1}{R_1 C_1} V_1 + \dfrac{1}{C_1} i \\[2ex] V_2' = -\dfrac{1}{R_2 C_2} V_2 + \dfrac{1}{C_2} i \end{cases} \tag{5}$$

where Q represents a battery capacity, $\eta$ represents charge/discharge efficiency, SOC represents a state of charge of the battery, and $V_1$ and $V_2$ represent polarization capacitance voltage drops.

A measurement equation is as follows:

$$V = V_{oc} + V_1 + V_2 + R_0 i \tag{6}$$

A relationship between an open-circuit voltage of the battery and an SOC is as follows:

$$V_{oc} = f(SOC) = \sum_{j=1}^{n} a_j SOC^i \tag{7}$$

When a sampling period is T, the measurement equation (6) may be rewritten as:

$$V_{0,k} - V_k = p_1[V_{k-1} - V_{0,k-1}] + p_2[V_{k-2} - V_{0,k-2}] + p_3 i_k + p_4 i_{k-1} + p_5 i_{k-2} \tag{8}$$

A relationship between parameters is shown in Formula (9):

$$\begin{cases} p_0 = T^2 \big/ (p_1 + p_2 - 1) \\ a = p_2 \big/ p_1 \\ b = -p_0(p_1 + 2p_2)\big/T \\ c = p_0(p_3 + p_4 + p_5)\big/T^2 \\ d = -p_0(p_4 + 2p_5)\big/T \\ R_0 = p_5 \big/ p_2 \\ R_1 C_1 = \min\left\{ (b + \sqrt{b^2 - 4a})\big/2, (b - \sqrt{b^2 - 4a})\big/2 \right\} \\ R_2 C_2 = \max\left\{ (b + \sqrt{b^2 - 4a})\big/2, (b - \sqrt{b^2 - 4a})\big/2 \right\} \\ R_2 = (R_2 C_2 c + b R_0 - R_2 C_2 R_0 - d)\big/(R_2 C_2 - R_1 C_1) \\ R_1 = c - R_2 - R_0 \end{cases} \tag{9}$$

For Formula (8), parameter identification may be performed by using a Kalman filtering algorithm, and a state space of a model parameter may be expressed as:

$$x_k = x_{k-1} + \xi_k$$
$$y_k = C_k x_k + \chi_k \tag{10}$$

where $\xi_k$ represents random interference, and $\chi_k$ represents random observation noise.

$$y_k = V_{0,k} - V_k$$
$$C_k = [V_{k-1} - V_{0,k-1}, V_{k-2} - V_{0,k-2}, i_k, i_{k-1}, i_{k-2}]$$
$$x_k = [p_{1,k}, p_{2,k}, p_{3,k}, p_{4,k}, p_{5,k}]^T \tag{11}$$

Statistical characteristics of system interference $\xi_k$, the observation noise $\chi_k$, and a state variable initial value $x_0$ are as follows:

$$E\{\xi_k\} = 0, E\{\chi_k\} = 0, E\{x_0\} = \mu_0$$

$$E\{[x_0 - \mu_0][x_0 - \mu_0]^T\} = p_0$$

$$C_{ov}\{\xi_j, \xi_k\} = \begin{cases} 0, j \neq k \\ M = diag\{m_1, m_2, \cdots m_5\}, j = k \end{cases}$$

$$C_{ov}\{\chi_j, \chi_k\} = \begin{cases} 0, j \neq k \\ N = \{n\}, j = k \end{cases} \tag{12}$$

where $u_0$ and $p_0$ are respectively used as a state variable and an error variance matrix initial value, to start a recursive algorithm, and a recursive process of the algorithm is as follows:

$$x_k = x_{k-1}$$

$$P_{k/k-1} = P_{k-1} + M$$

$$k_k = P_{k/k-1}C_k^T[C_k P_{k/k-1}C_k^T + N]^{-1}$$

$$P_k = [I - k_k C_k]P_{k/k-1}$$

$$x_k = x_{k/k-1} + k_k y_k - C_k x_{k/k-1} \tag{13}$$

where $y_k$ represents an end voltage sampling value $V_k$, I represents an identity matrix, $x_{k/k-1}$ represents a state variable prediction value, $x_k$ represents a state variable output value, $p_{k/k-1}$ represents an error covariance prediction value, $p_k$ represents an error covariance update value, and $k_k$ represents a filtering gain update value.

According to an optimal status estimation $x_{k+1}$ that is obtained through recursion according to the Kalman filtering algorithm, a battery model parameter may be obtained with reference to Formula (9).

It should be noted that the equivalent circuit model of the battery may be a third-order equivalent circuit model. A structure of the third-order equivalent circuit model is shown in FIG. 4, where $R_0$ represents an ohmic resistance, $R_1$ and $C_1$, $R_2$ and $C_2$, and $R_3$ and $C_3$ represent polarization effects of the battery, and $R_1$, $R_2$, and $R_3$ are respectively corresponding to a charge transfer resistance, a diffusional impedance 1, and a diffusional impedance 2. A calculation method of the third-order equivalent circuit model is similar to the calculation method of the second-order equivalent circuit model. Details are not described herein again.

(3) Obtain the charge transfer resistance model and the diffusional impedance model. For example, a relationship table between a charge transfer resistance of a battery, and a temperature of the battery, a state of charge SOC of the battery, and a charge/discharge current may be established, as listed in Table 4. A relationship table between a diffusional impedance of a battery, and a temperature of the battery, a state of charge SOC of the battery, and a charge/discharge current may be established, as listed in Table 5.

**Table 4**

| State of charge SOC | Current I | Temperature T | | | | |
|---|---|---|---|---|---|---|
| | | 60°C | 40°C | 25°C | ... | -20°C |
| 95% | 0.01 A | 21.54 mΩ | 15.225 mΩ | 25.696 mΩ | ... | 1011.09 mΩ |
| | 0.1 A | 15.76 mΩ | 21.105 mΩ | 25.718 mΩ | ... | 625.95 mΩ |
| | 0.5 A | 11.8 mΩ | 15.183 mΩ | 23.474 mΩ | ... | 194.4 mΩ |
| | 1 A | 10.94 mΩ | 14.091 mΩ | 21.23 mΩ | ... | - |
| | ... | ... | ... | ... | ... | ... |
| | 5 A | 9.6 mΩ | 12.159 mΩ | 16.852 mΩ | ... | - |
| ... | | | | | | |
| 10% | 0.01 A | 10.96 mΩ | 16.842 mΩ | 31.394 mΩ | ... | 1125.63 mΩ |
| | 0.1 A | 9.92 mΩ | 20.664 mΩ | 28.292 mΩ | ... | - |
| | 0.5 A | 10.68 mΩ | 15.288 mΩ | 25.608 mΩ | ... | - |
| | 1 A | 11.68 mΩ | 15.477 mΩ | 22.33 mΩ | ... | - |
| | ... | ... | ... | ... | ... | ... |
| | 5 A | 11.48 mΩ | 13.776 mΩ | 17.842 mΩ | ... | - |
| ... | | | | | | |

**Table 5**

| State of charge SOC | Current I | Temperature T | | | | |
|---|---|---|---|---|---|---|
| | | 60°C | 40°C | 25°C | ... | -20°C |
| 95% | 0.01 A | 86.16 mΩ | 57.275 mΩ | 91.104 mΩ | ... | 2359.21 mΩ |
| | 0.1 A | 63.04 mΩ | 79.395 mΩ | 91.182 mΩ | ... | 1460.55 mΩ |
| | 0.5 A | 47.2 mΩ | 57.117 mΩ | 83.226 mΩ | ... | 453.6 mΩ |
| | 1 A | 43.76 mΩ | 53.009 mΩ | 75.27 mΩ | ... | - |
| | ... | ... | ... | ... | ... | ... |
| | 5 A | 38.4 mΩ | 45.741 mΩ | 59.748 mΩ | ... | - |
| ... | | | | | | |
| 10% | 0.01 A | 43.84 mΩ | 63.358 mΩ | 111.306 mΩ | ... | 2626.47 mΩ |
| | 0.1 A | 39.68 mΩ | 77.736 mΩ | 100.308 mΩ | ... | - |
| | 0.5 A | 42.72 mΩ | 57.512 mΩ | 90.792 mΩ | ... | - |
| | 1 A | 46.72 mΩ | 58.223 mΩ | 79.17 mΩ | ... | - |
| | ... | ... | ... | ... | ... | ... |
| | 5 A | 45.92 mΩ | 51.824 mΩ | 63.258 mΩ | ... | - |
| ... | | | | | | |

204. Determine current-moment internal resistance data of the to-be-measured battery based on the current-moment internal resistance response type, the current-moment temperature, the current-moment charge/discharge current, and the previous-moment state of charge value.

The apparatus for estimating a state of charge of a battery determines the current-moment internal resistance data of the to-be-measured battery based on the current-moment internal resistance response type, the current-moment temperature, the current-moment charge/discharge current, and the previous-moment state of charge value.

It should be noted that, for different internal resistance response types, the apparatus for estimating a state of charge of a battery needs to invoke different correspondences. For example, when the current-moment internal resistance response type is a first response type, a second correspondence is first determined based on the first response type, where the second correspondence is used to indicate a correspondence between an ohmic resistance of the to-be-measured battery, and a temperature and a state of charge value that are of the to-be-measured battery. The current-moment internal resistance data of the to-be-measured battery is determined based on the second correspondence, the current-moment temperature, and the previous-moment state of charge value, where the internal resistance data is a current-moment ohmic resistance.

For another example, when the current-moment internal resistance response type is a second response type, a second correspondence and a third correspondence are first determined based on the second response type, where the second correspondence is used to indicate a correspondence between the ohmic resistance of the to-be-measured battery, and a temperature and a state of charge value that are of the to-be-measured battery, and the third correspondence is used to indicate a correspondence between the charge transfer resistance of the to-be-measured battery, and the temperature, the state of charge, and the charge/discharge current that are of the to-be-measured battery. The current-moment internal resistance data of the to-be-measured battery is determined based on the second correspondence, the third correspondence, the current-moment temperature, the current-moment charge/discharge current, and the previous-moment state of charge value, where the internal resistance data is a sum of a current-moment ohmic resistance and a current-moment charge transfer resistance.

For another example, when the current-moment internal resistance response type is a third response type, a second correspondence, a third correspondence, and a fourth correspondence are first determined based on the third response type, where the second correspondence is used to indicate a correspondence between the ohmic resistance of the to-be-measured battery, and a temperature and a state of charge value that are of the to-be-measured battery, the third correspondence is used to indicate a correspondence between the charge transfer resistance of the to-be-measured battery, and the temperature, the state of charge, and the charge/discharge current that are of the to-be-measured battery, and the fourth correspondence is used to indicate a correspondence between the diffusional impedance of the to-be-measured battery, and the temperature, the state of charge value, and the charge/discharge current that are of the to-be-measured battery. The current-moment internal resistance data of the to-be-measured battery is determined based on the second correspondence, the third correspondence, the fourth correspondence, the current-moment temperature, the current-moment charge/discharge current, and the previous-moment state of charge value, where the internal resistance data is a sum of a current-moment ohmic resistance, a current-moment charge transfer resistance, and a current-moment diffusional impedance. It should be noted that, when the current-moment internal resistance response type is the third response type, a polarization resistance may be obtained based on a preconfigured polarization resistance correspondence, where the polarization resistance is a sum of a charge transfer resistance and a diffusional impedance, and the preconfigured polarization resistance correspondence may be divided into the third correspondence and the fourth correspondence. A process of determining the internal resistance data is similar, and details are not described herein again.

For example, if the current-moment internal resistance response type is the first response type, Table 2 is searched for corresponding internal resistance data based on the current-moment temperature and the previous-moment state of charge value. Specifically, if the current-moment temperature is 40°C, and the previous-moment state of charge value is 90%, the ohmic resistance corresponding to the to-be-measured battery is 41.3 mΩ. For another example, if the current-moment internal resistance response type of the to-be-measured battery is the second response type, both Table 2 and Table 4 are searched for corresponding internal resistance data based on the current-moment temperature, the current-moment charge/discharge current, and the previous-moment state of charge value. Specifically, if the current-moment temperature is 60°C, the current-moment charge/discharge current is 0.1 A, and the previous-moment state of charge value is 95%, the ohmic resistance corresponding to the to-be-measured battery is 41.5 mΩ, and the charge transfer resistance corresponding to the to-be-measured battery is 21.105 mΩ. For another example, if the current-moment internal resistance response type of the to-be-measured battery is the third response type, Table 2, Table 4, and Table 5 are respectively searched for a corresponding ohmic resistance, a corresponding charge transfer resistance, and a corresponding diffusional impedance based on the current-moment temperature, the current-moment charge/discharge current, and the previous-moment state of charge value. Specifically, if the current-moment temperature is 25°C, the current-moment charge/discharge current is 0.5 A, and the previous-moment state of charge value is 95%, the ohmic resistance corresponding to the to-be-measured battery is 81.3 mΩ, the charge transfer resistance corresponding to the to-be-measured battery is 23.474 mΩ, and the diffusional impedance corresponding to the to-be-measured battery is 83.226 mΩ.

It may be understood that, Table 4 and Table 5 are obtained by dividing Table 3. When the current-moment internal resistance response type is the third response type, the polarization internal resistance may also be obtained by directly searching Table 3, and then the polarization internal resistance and the ohmic resistance that is obtained by searching Table 2 are summed up, to obtain the current-moment internal resistance data. For example, if the current-moment internal resistance response type of the to-be-measured battery is the third response type, Table 2 and Table 3 are respectively searched for a corresponding ohmic resistance and a corresponding polarization resistance based on the current-moment temperature, the current-moment charge/discharge current, and the previous-moment state of charge value. Specifically, if the current-moment temperature is 25°C, the current-moment charge/discharge current is 0.5 A, and the previous-moment state of charge value is 95%, the ohmic resistance corresponding to the to-be-measured battery is 81.3 mΩ, and the polarization resistance corresponding to the to-be-measured battery is 106.7 mΩ.

205. Determine a current-moment unusable capacity of the to-be-measured battery based on the current-moment internal resistance data, the current-moment charge/discharge current, and the current-moment temperature.

The apparatus for estimating a state of charge of a battery determines the current-moment unusable capacity of the to-be-measured battery based on the current-moment internal resistance data, the current-moment charge/discharge current, and the current-moment temperature, where the unusable capacity is a state of charge value when the to-be-measured battery cannot release a capacity.

Specifically, the apparatus for estimating a state of charge of a battery determines a current-moment internal resistance voltage of the to-be-measured battery based on the current-moment internal resistance data and the current-moment charge/discharge current; determines a current-moment unusable voltage of the to-be-measured battery based on the current-moment internal resistance voltage and a preconfigured cutoff voltage; and determines the current-moment unusable capacity of the to-be-measured battery based on the current-moment unusable voltage, the current-moment temperature, and a preconfigured fifth correspondence, where the fifth correspondence is used to indicate a correspondence between the open-circuit voltage of the to-be-measured battery, and the temperature and the state of charge value that are of the to-be-measured battery.

The unusable voltage may be calculated according to Formula (14):

$$\text{Unusable voltage} = I \times R + \text{cutoff voltage} \tag{14}$$

where I represents the current-moment charge/discharge current, and R represents the internal resistance data, determined in step 204, of the to-be-measured battery. The cutoff voltage is preset according to an actual case, and different models of batteries may have different cutoff voltages. This is not specifically limited herein.

Then, the apparatus for estimating a state of charge of a battery obtains the unusable capacity based on the calculated unusable voltage and by searching the fifth correspondence, where the fifth correspondence may be a relationship table between an open-circuit voltage of the battery and a temperature of the battery, and a state of charge SOC of the battery, as listed in Table 6.

**Table 6**

| State of charge SOC | Temperature T | | | | | |
|---|---|---|---|---|---|---|
| | -20°C | -10°C | 0°C | 25°C | 40°C | 60°C |
| 100% | 4.3315 V | 4.3309 V | 4.3278 V | 4.3245 V | 4.3201 V | 4.3137 V |
| 95% | 4.2384 V | 4.2516 V | 4.2581 V | 4.2652 V | 4.2614 V | 4.256 V |
| 90% | 4.1724 V | 4.1894 V | 4.1987 V | 4.2096 V | 4.2055 V | 4.2004 V |
| ... | ... | ... | ... | ... | ... | ... |
| 10% | 3.6993 V | 3.7016 V | 3.695 V | 3.6896 V | 3.6828 V | 3.6711 V |
| 5% | 3.642 V | 3.6657 V | 3.6658 V | 3.6754 V | 3.6642 V | 3.6329 V |
| 0% | 3.28 V | 3.3062 V | 3.284 V | 3.3754 V | 3.3389 V | 3.2079 V |

It should be noted that Table 6 lists only a part of data, and in actual application, omitted data may be obtained through calculation based on the provided data. Details are not described herein.

206. Determine a current-moment state of charge value of the to-be-measured battery based on the current-moment coulomb capacity and the current-moment unusable capacity.

The apparatus for estimating a state of charge of a battery determines the current-moment state of charge value of the to-be-measured battery based on the current-moment coulomb capacity and the current-moment unusable capacity.

Specifically, the apparatus for estimating a state of charge of a battery first determines an initial capacity based on the previous-moment state of charge value $SOC_{start}$ and a full charge capacity (full charge capacity, FCC) of the to-be-measured battery, and then obtains the current-moment state of charge value of the to-be-measured battery obtained through calculation by using the obtained coulomb capacity (coulomb capacity, CC) and the calculated unusable capacity (unusable capacity, UUC).

For example, the apparatus for estimating a state of charge of a battery estimates the current-moment state of charge value according to Formula (15):

$$SOC = \frac{SOC_{start} \times FCC - CC - UUC}{FCC - UUC}$$

(15)

where $SOC_{start}$ represents the previous-moment state of charge, and is obtained according to Table 6, FCC represents the full charge capacity, CC represents the coulomb capacity, and UUC represents the unusable capacity.

In this embodiment of this application, first, the total internal resistance of the battery is obtained based on the initial relationship table between the temperature of the battery, the state of charge SOC of the battery, and the current of the battery; and the total internal resistance is further divided into the ohmic resistance, the charge transfer resistance, and the diffusional impedance based on different time constants by using the equivalent circuit model method, to obtain a new battery internal resistance model. Factors affecting the internal resistance of the battery, such as the discharge duration and the current value are fully considered, so that a more precise battery internal resistance model is established. Then, the current-moment temperature of the to-be-measured battery, the previous-moment charge of state SOC of the to-be-measured battery, and the current-moment charge/discharge current are obtained in real time. The internal resistance response type is first determined based on a current running time, then corresponding internal resistance data is extracted from the battery internal resistance model according to the foregoing condition, and the unusable capacity of the battery is accurately calculated by using the internal resistance of the battery, so that the current-moment state of charge SOC of the battery is accurately estimated. The state of charge of the battery is estimated according to the battery internal resistance model with higher accuracy, thereby improving accuracy of an estimated value of the state of charge of the battery.

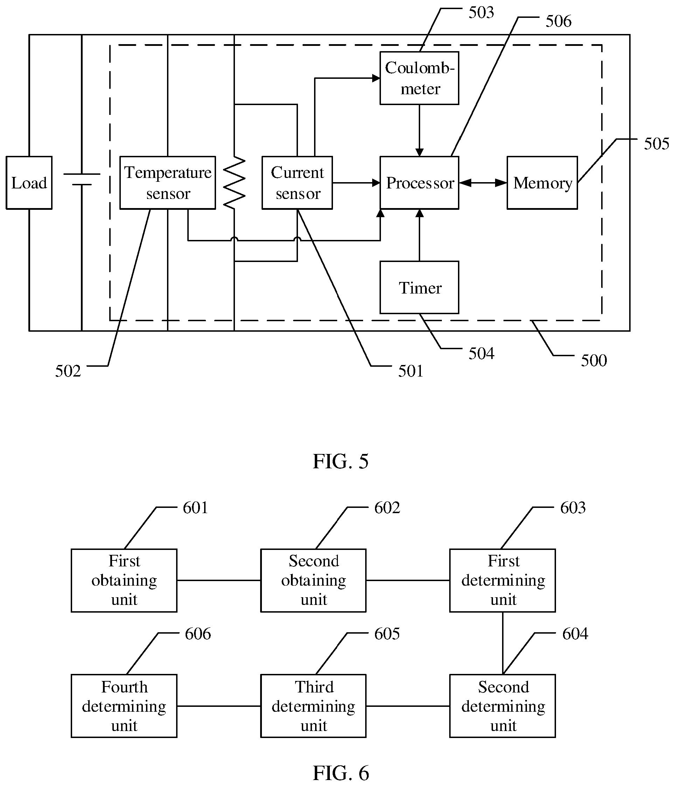

The foregoing describes the method for estimating a state of charge of a battery in the embodiment of this application. The following describes an apparatus for estimating a state of charge of a battery in the embodiments of this application. Referring to FIG. 5, an embodiment of an apparatus 500 for estimating a state of charge of a battery according to an embodiment of this application includes:

a current sensor 501, a temperature sensor 502, a coulombmeter 503, a timer 504, a memory 505, and a processor 506.

The current sensor 501 is configured to obtain a charge/discharge current of a to-be-measured battery in real time and transmit the charge/discharge current to the processor 506.

The temperature sensor 502 is configured to obtain a temperature of the to-be-measured battery in real time and transmit the temperature to the processor 506.

The coulombmeter 503 is configured to accumulate currents flowing through the to-be-measured battery to obtain a current-moment coulomb capacity, and transmit the current-moment coulomb capacity to the processor 506.

The timer 504 is configured to obtain discharge duration of the to-be-measured battery and transmit the discharge duration to the processor 506.

The memory 505 is configured to store parameter information of the to-be-measured battery, where the parameter information includes a previous-moment state of charge value.

The processor 506 is configured to estimate a current-moment state of charge value of the to-be-measured battery based on the parameter information, a current-moment charge/discharge current, a current-moment temperature, and the current-moment coulomb capacity.

In this embodiment of this application, a state of charge of a battery is estimated according to a battery internal resistance model with higher accuracy, thereby improving accuracy of an estimated value of the state of charge of the battery.

In a possible implementation, the memory 505 may further store a first correspondence. The first correspondence is used to indicate a correspondence between the discharge duration of the to-be-measured battery and an internal resistance response type of the to-be-measured battery.

In a possible implementation, the memory 505 further stores a second correspondence, a third correspondence, and a fourth correspondence. The second correspondence is used to indicate a correspondence between an ohmic resistance of the to-be-measured battery, and a temperature and a state of charge value that are of the to-be-measured battery. The third correspondence is used to indicate a correspondence between a charge transfer resistance of the to-be-measured battery, and the temperature, the state of charge, and the charge/discharge current. The fourth correspondence is used to indicate a correspondence between a diffusional impedance of the to-be-measured battery, and the temperature, the state of charge value, and the charge/discharge current that are of the to-be-measured battery.

In a possible implementation, the memory 505 may further store data information obtained by each of the current sensor 501, the temperature sensor 502, the coulombmeter 503, and the timer 504.

The processor 506 is a control center of the apparatus 500 for estimating a state of charge of a battery, and may perform processing according to the specified method for estimating a state of charge of a battery. The processor 506 is connected to all the parts of the entire apparatus for estimating a state of charge of a battery by using various interfaces and lines, and executes various functions of the apparatus for estimating a state of charge of a battery and processes data by running or executing a software program and/or module stored in the memory 505 and by invoking data stored in the memory 505, to estimate a state of charge value of the battery.

The memory 505 may be configured to store the software program and module. The processor 506 executes various functional applications and data processing of the apparatus 500 for estimating a state of charge of a battery by running the software program and module stored in the memory 505. The memory 505 may mainly include a program storage area and a data storage area. The program storage area may store an operating system, an application program required by at least one function (for example, a first correspondence), and the like. The data storage area may store data created according to use of a device (for example, a current-moment coulomb capacity) and the like. In addition, the memory 505 may include a high-speed random access memory, and may further include a nonvolatile memory, for example, at least one magnetic disk storage device, a flash memory, or another volatile solid-state storage device. A program and an obtained data stream in the method for estimating a state of charge of a battery provided in this embodiment of this application are stored in the memory 505. When the program or the data stream needs to be used, the processor 506 invokes the program or the data stream from the memory 505.

The foregoing describes in detail the apparatus for estimating a state of charge of a battery in this embodiment of this application from a perspective of hardware processing with reference to FIG. 5. The following describes in detail the apparatus for estimating a state of charge of a battery in an embodiment of this application from a perspective of functional modules. Referring to FIG. 6, another embodiment of an apparatus for estimating a state of charge of a battery according to an embodiment of this application includes:

> a first obtaining unit 601, configured to obtain, at a preconfigured time interval, a current-moment charge/discharge current, a current-moment temperature, a current-moment coulomb capacity, and a previous-moment state of charge value of a to-be-measured battery in real time, where the preconfigured time interval is duration between a previous moment and a current moment;
> a second obtaining unit 602, configured to obtain discharge duration of the to-be-measured battery, where the discharge duration is duration of a charge/discharge current;
> a first determining unit 603, configured to determine a current-moment internal resistance response type of the to-be-measured battery based on the discharge duration;
> a second determining unit 604, configured to determine current-moment internal resistance data of the to-be-measured battery based on the current-moment internal resistance response type, the current-moment temperature, the current-moment charge/discharge current, and the previous-moment state of charge value;
> a third determining unit 605, configured to determine a current-moment unusable capacity of the to-be-measured battery based on the current-moment internal resistance data, the current-moment charge/discharge current, and the current-moment temperature, where the unusable capacity is a state of charge value when the to-be-measured battery cannot release a capacity; and
> a fourth determining unit 606, configured to determine a current-moment state of charge value of the to-be-measured battery based on the current-moment coulomb capacity and the current-moment unusable capacity.

In a possible implementation, the first determining unit 603 is specifically configured to:
determine the current-moment internal resistance response type of the to-be-measured battery based on the discharge duration and a preconfigured first correspondence, where the first correspondence is used to indicate a correspondence between the discharge duration of the to-be-measured battery and the internal resistance response type of the to-be-measured battery.

In a possible implementation, the first correspondence includes:

> when the discharge duration is less than or equal to a first threshold, the internal resistance response type is a first response type, and the first response type includes an ohmic resistance;
> when the discharge duration is greater than a first threshold and less than or equal to a second threshold, the internal resistance response type is a second response type, and the second response type includes an ohmic resistance and a charge transfer resistance; or
> when the discharge duration is greater than a second threshold, the internal resistance response type is a third response type, and the third response type includes an ohmic resistance, a charge transfer resistance, and a diffusional impedance.

In a possible implementation, the second determining unit 604 is specifically configured to:

> determine a second correspondence based on the first response type, where the second correspondence is used to indicate a correspondence between the ohmic resistance of the to-be-measured battery, and a temperature and a state of charge value that are of the to-be-measured battery, and

determine the current-moment internal resistance data of the to-be-measured battery based on the second correspondence, the current-moment temperature, the current-moment charge/discharge current, and the previous-moment state of charge value, where the internal resistance data is a current-moment ohmic resistance; or determine a second correspondence and a third correspondence based on the second response type, where the second correspondence is used to indicate a correspondence between the ohmic resistance of the to-be-measured battery, and a temperature and a state of charge value that are of the to-be-measured battery, and the third correspondence is used to indicate a correspondence between the charge transfer resistance of the to-be-measured battery, and the temperature, the state of charge, and the charge/discharge current that are of the to-be-measured battery, and

determine the current-moment internal resistance data of the to-be-measured battery based on the second correspondence, the third correspondence, the current-moment temperature, the current-moment charge/discharge current, and the previous-moment state of charge value, where the internal resistance data is a sum of a current-moment ohmic resistance and a current-moment charge transfer resistance; or

determine a second correspondence, a third correspondence, and a fourth correspondence based on the third response type, where the second correspondence is used to indicate a correspondence between the ohmic resistance of the to-be-measured battery, and a temperature and a state of charge value that are of the to-be-measured battery, the third correspondence is used to indicate a correspondence between the charge transfer resistance of the to-be-measured battery, and the temperature, the state of charge, and the charge/discharge current that are of the to-be-measured battery, and the fourth correspondence is used to indicate a correspondence between the diffusional impedance of the to-be-measured battery, and the temperature, the state of charge value, and the charge/discharge current that are of the to-be-measured battery, and

determine the current-moment internal resistance data of the to-be-measured battery based on the second correspondence, the third correspondence, the fourth correspondence, the current-moment temperature, the current-moment charge/discharge current, and the previous-moment state of charge value, where the internal resistance data is a sum of a current-moment ohmic resistance, a current-moment charge transfer resistance, and a current-moment diffusional impedance.

The third determining unit 605 is specifically configured to:

determine a current-moment internal resistance voltage of the to-be-measured battery based on the current-moment internal resistance data and the current-moment charge/discharge current;

determine a current-moment unusable voltage of the to-be-measured battery based on the current-moment internal resistance voltage and a preconfigured cutoff voltage; and

determine the current-moment unusable capacity of the to-be-measured battery based on the current-moment unusable voltage, the current-moment temperature, and a preconfigured fifth correspondence, where the fifth correspondence is used to indicate a correspondence between an open-circuit voltage of the to-be-measured battery, and the temperature and the state of charge value that are of the to-be-measured battery.

In a possible implementation, the fourth determining unit 606 is specifically configured to:

determine an initial capacity based on a preconfigured full charge capacity, the previous-moment state of charge value, and the fifth correspondence, where the initial capacity is a previous-moment capacity of the to-be-measured battery;

determine a current-moment residual capacity of the to-be-measured battery based on the initial capacity, the current-moment coulomb capacity, and the current-moment unusable capacity; and

determine the current-moment state of charge value of the to-be-measured battery based on the current-moment residual capacity, the preconfigured full charge capacity, and the current-moment unusable capacity.

This application further provides a terminal. The terminal includes a battery, and an apparatus for estimating a state of charge of a battery.

The apparatus for estimating a state of charge of a battery is the apparatus for estimating a state of charge of a battery according to any one of the foregoing embodiments. For a structure of the apparatus for estimating a state of charge of a battery, refer to the foregoing embodiments. Details are not described herein again.

The computer program product includes one or more computer instructions. When the computer program instruction is loaded and executed on a computer, some or all of the procedures or functions according to the embodiments of this application are generated. The computer may be a general-purpose computer, a special-purpose computer, a computer network, or another programmable apparatus. The computer instructions may be stored in a computer-readable storage medium or may be transmitted from a computer-readable storage medium to another computer-readable storage medium. For example, the computer instruction may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server, a data center, or the like, integrating one or more usable media. The usable medium may be a magnetic medium (for example, a floppy disk, a hard disk, or a magnetic tape), an optical medium (for example, a DVD), a semiconductor medium (for example, a solid-state drive (solid state disk, SSD)), or the like.

When the integrated unit is implemented in the form of a software functional unit and sold or used as an independent product, the integrated unit may be stored in a computer-readable storage medium. Based on such an understanding, the technical solutions of this application essentially, or the part contributing to the prior art, or all or some of the technical solutions may be implemented in the form of a software product. The computer software product is stored in a storage medium and includes several instructions for instructing a computer device (which may be a personal computer, a server, a network device, or the like) to perform all or some of the steps of the methods described in the embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

## Claims

1. A method for estimating a state of charge of a battery, comprising:

   obtaining (201), in a preconfigured time interval, a current-moment charge/discharge current, a current-moment temperature, a current-moment coulomb capacity, and a previous-moment state of charge value of a to-be-measured battery in real time, wherein the preconfigured time interval is duration between a previous moment and a current moment;
   obtaining (202) discharge duration of the to-be-measured battery, wherein the discharge duration is duration of a charge/discharge current;
   determining a current-moment internal resistance response type of the to-be-measured battery based on the discharge duration and a preconfigured first correspondence, wherein the first correspondence is used to indicate a correspondence between the discharge duration of the to-be-measured battery and the internal resistance response type of the to-be-measured battery;
   determining (204) current-moment internal resistance data of the to-be-measured battery based on the current-moment internal resistance response type, the current-moment temperature, the current-moment charge/-discharge current, and the previous-moment state of charge value;
   determining (205) a current-moment unusable capacity of the to-be-measured battery based on the current-moment internal resistance data, the current-moment charge/discharge current, and the current-moment temperature, wherein the unusable capacity is a state of charge value when the to-be-measured battery cannot release a capacity, and the determining (205) a current-moment unusable capacity of the to-be-measured battery based on the current-moment internal resistance data, the current-moment charge/discharge current, and the current-moment temperature comprises:

      determining a current-moment internal resistance voltage of the to-be-measured battery based on the current-moment internal resistance data and the current-moment charge/discharge current, wherein the internal resistance voltage is a voltage loss caused by an internal resistance of the to-be-measured battery;
      determining a current-moment unusable voltage of the to-be-measured battery based on the current-moment internal resistance voltage and a preconfigured cutoff voltage; and
      determining the current-moment unusable capacity of the to-be-measured battery based on the current-moment unusable voltage, the current-moment temperature, and a preconfigured fifth correspondence, wherein the fifth correspondence is used to indicate a correspondence between an open-circuit voltage of the to-be-measured battery, and the temperature and the state of charge value that are of the to-be-measured battery; and

   determining (206) a current-moment state of charge value of the to-be-measured battery based on the current-moment coulomb capacity and the current-moment unusable capacity.

**2.** The estimation method according to claim 1, wherein
the first correspondence comprises:

when the discharge duration is less than or equal to a first threshold, the internal resistance response type is a first response type, and the first response type comprises an ohmic resistance;
when the discharge duration is greater than a first threshold and less than or equal to a second threshold, the internal resistance response type is a second response type, and the second response type comprises an ohmic resistance and a charge transfer resistance; or
when the discharge duration is greater than a second threshold, the internal resistance response type is a third response type, and the third response type comprises an ohmic resistance, a charge transfer resistance, and a diffusional impedance.

**3.** The estimation method according to claim 2, wherein the determining current-moment internal resistance data of the to-be-measured battery based on the current-moment internal resistance response type, the current-moment temperature, the current-moment charge/discharge current, and the previous-moment state of charge value comprises:

determining a second correspondence based on the first response type, wherein the second correspondence is used to indicate a correspondence between the ohmic resistance of the to-be-measured battery, and a temperature and a state of charge value that are of the to-be-measured battery; and
determining the current-moment internal resistance data of the to-be-measured battery based on the second correspondence, the current-moment temperature, the current-moment charge/discharge current, and the previous-moment state of charge value, wherein the internal resistance data is a current-moment ohmic resistance.

**4.** The estimation method according to claim 2, wherein the determining current-moment internal resistance data of the to-be-measured battery based on the current-moment internal resistance response type, the current-moment temperature, the current-moment charge/discharge current, and the previous-moment state of charge value comprises:

determining a second correspondence and a third correspondence based on the second response type, wherein the second correspondence is used to indicate a correspondence between the ohmic resistance of the to-be-measured battery, and a temperature and a state of charge value that are of the to-be-measured battery, and the third correspondence is used to indicate a correspondence between the charge transfer resistance of the to-be-measured battery, and the temperature, the state of charge, and the charge/discharge current that are of the to-be-measured battery; and
determining the current-moment internal resistance data of the to-be-measured battery based on the second correspondence, the third correspondence, the current-moment temperature, the current-moment charge/-discharge current, and the previous-moment state of charge value, wherein the internal resistance data is a sum of a current-moment ohmic resistance and a current-moment charge transfer resistance.

**5.** The estimation method according to claim 2, wherein the determining current-moment internal resistance data of the to-be-measured battery based on the current-moment internal resistance response type, the current-moment temperature, the current-moment charge/discharge current, and the previous-moment state of charge value comprises:

determining a second correspondence, a third correspondence, and a fourth correspondence based on the third response type, wherein the second correspondence is used to indicate a correspondence between the ohmic resistance of the to-be-measured battery, and a temperature and a state of charge value that are of the to-be-measured battery, the third correspondence is used to indicate a correspondence between the charge transfer resistance of the to-be-measured battery, and the temperature, the state of charge, and the charge/discharge current that are of the to-be-measured battery, and the fourth correspondence is used to indicate a correspondence between the diffusional impedance of the to-be-measured battery, and the temperature, the state of charge value, and the charge/discharge current that are of the to-be-measured battery; and
determining the current-moment internal resistance data of the to-be-measured battery based on the second correspondence, the third correspondence, the fourth correspondence, the current-moment temperature, the current-moment charge/discharge current, and the previous-moment state of charge value, wherein the internal resistance data is a sum of a current-moment ohmic resistance, a current-moment charge transfer resistance, and a current-moment diffusional impedance.

6.  The estimation method according to any one of claims 1 to 5, wherein the determining a current-moment state of charge value of the to-be-measured battery based on the current-moment coulomb capacity and the current-moment unusable capacity comprises:

    determining an initial capacity based on a preconfigured full charge capacity, the previous-moment state of charge value, and the fifth correspondence, wherein the initial capacity is a previous-moment capacity of the to-be-measured battery;
    determining a current-moment residual capacity of the to-be-measured battery based on the initial capacity, the current-moment coulomb capacity, and the current-moment unusable capacity; and
    determining the current-moment state of charge value of the to-be-measured battery based on the current-moment residual capacity, the preconfigured full charge capacity, and the current-moment unusable capacity.

7.  An apparatus (500) for estimating a state of charge of a battery, comprising:

    a first obtaining unit (601), configured to obtain, in a preconfigured time interval, a current-moment charge/-discharge current, a current-moment temperature, a current-moment coulomb capacity, and a previous-moment state of charge value of a to-be-measured battery in real time, wherein the preconfigured time interval is duration between a previous moment and a current moment;
    a second obtaining unit (602), configured to obtain discharge duration of the to-be-measured battery, wherein the discharge duration is duration of a charge/discharge current;
    a first determining unit (603), configured to determine a current-moment internal resistance response type of the to-be-measured battery based on the discharge duration and a preconfigured first correspondence, wherein the first correspondence is used to indicate a correspondence between the discharge duration of the to-be-measured battery and the internal resistance response type of the to-be-measured battery;
    a second determining unit (604), configured to determine current-moment internal resistance data of the to-be-measured battery based on the current-moment internal resistance response type, the current-moment temperature, the current-moment charge/discharge current, and the previous-moment state of charge value;
    a third determining unit (605), configured to determine a current-moment unusable capacity of the to-be-measured battery based on the current-moment internal resistance data, the current-moment charge/discharge current, and the current-moment temperature, wherein the unusable capacity is a state of charge value when the to-be-measured battery cannot release a capacity, and the third determining unit (605) is specifically configured to:

    determine a current-moment internal resistance voltage of the to-be-measured battery based on the current-moment internal resistance data and the current-moment charge/discharge current, wherein the internal resistance voltage is a voltage loss caused by an internal resistance of the to-be-measured battery;
    determine a current-moment unusable voltage of the to-be-measured battery based on the current-moment internal resistance voltage and a preconfigured cutoff voltage; and
    determine the current-moment unusable capacity of the to-be-measured battery based on the current-moment unusable voltage, the current-moment temperature, and a preconfigured fifth correspondence, wherein the fifth correspondence is used to indicate a correspondence between an open-circuit voltage of the to-be-measured battery, and the temperature and the state of charge value that are of the to-be-measured battery; and

    a fourth determining unit (606), configured to determine a current-moment state of charge value of the to-be-measured battery based on the current-moment coulomb capacity and the current-moment unusable capacity.

8.  The estimation apparatus according to claim 7, wherein the first correspondence comprises:

    when the discharge duration is less than or equal to a first threshold, the internal resistance response type is a first response type, and the first response type comprises an ohmic resistance;
    when the discharge duration is greater than a first threshold and less than or equal to a second threshold, the internal resistance response type is a second response type, and the second response type comprises an ohmic resistance and a charge transfer resistance; or
    when the discharge duration is greater than a second threshold, the internal resistance response type is a third response type, and the third response type comprises an ohmic resistance, a charge transfer resistance, and a diffusional impedance.

9. A terminal, comprising:

   a battery, and an apparatus (500) for estimating a state of charge of a battery, wherein
   the apparatus (500) for estimating a state of charge of a battery is the apparatus (500) for estimating a state of
   charge of a battery according to claim 7 or 8.

10. A computer program product including instructions, which when the computer program product is run on a computer,
    cause the computer to perform the method of any one of claims 1 to 6.

**Patentansprüche**

1. Verfahren zum Schätzen eines Ladezustands einer Batterie, das Folgendes umfasst:

   Ermitteln (201) eines momentanen Lade-/Entladestroms, einer momentanen Temperatur, einer momentanen
   Coulomb-Kapazität und eines vorherigen Ladezustandswerts einer zu messenden Batterie in Echtzeit in einem
   vorkonfigurierten Zeitintervall, wobei das vorkonfigurierte Zeitintervall die Zeitspanne zwischen einem vorherigen Zeitpunkt und einem momentanen Zeitpunkt ist;
   Ermitteln (202) einer Entladedauer der zu messenden Batterie, wobei die Entladedauer die Dauer eines
   Lade-/Entladestroms ist;
   Bestimmen eines momentanen Innenwiderstandsreaktionstyps der zu messenden Batterie basierend auf der
   Entladedauer und einer vorkonfigurierten ersten Entsprechung, wobei die erste Entsprechung dazu dient, eine
   Entsprechung zwischen der Entladedauer der zu messenden Batterie und dem Innenwiderstandsreaktionstyp
   der zu messenden Batterie anzugeben;
   Bestimmen (204) der momentanen Innenwiderstandsdaten der zu messenden Batterie basierend auf dem
   momentanen Innenwiderstandsreaktionstyp, der momentanen Temperatur, dem momentanen Lade-/Entladestrom und dem vorherigen Ladezustandswert;
   Bestimmen (205) einer momentanen nicht nutzbaren Kapazität der zu messenden Batterie basierend auf den
   momentanen Innenwiderstandsdaten, dem momentanen Lade-/Entladestrom und der momentanen Temperatur, wobei die nicht nutzbare Kapazität ein Ladezustandswert ist, wenn die zu messende Batterie keine Kapazität
   freigeben kann, und das Bestimmen (205) einer momentanen nicht nutzbaren Kapazität der zu messenden
   Batterie basierend auf den momentanen Innenwiderstandsdaten, dem momentanen Lade-/Entladestrom und
   der momentanen Temperatur Folgendes umfasst:

      Bestimmen einer momentanen Spannung über dem Innenwiderstand der zu messenden Batterie basierend
      auf den momentanen Innenwiderstandsdaten und dem momentanen Lade-/Entladestrom, wobei die
      Spannung über dem Innenwiderstand ein Spannungsverlust ist, der durch den Innenwiderstand der zu
      messenden Batterie verursacht wird;
      Bestimmen einer momentanen nicht nutzbaren Spannung der zu messenden Batterie basierend auf der
      momentanen Innenwiderstandsspannung und einer vorkonfigurierten Entladeschlussspannung und
      Bestimmen der momentanen nicht nutzbaren Kapazität der zu messenden Batterie basierend auf der
      momentanen nicht nutzbaren Spannung, der momentanen Temperatur und einer vorkonfigurierten fünften
      Entsprechung, wobei die fünfte Entsprechung dazu dient, eine Entsprechung zwischen einer Leerlaufspannung der zu messenden Batterie und der Temperatur und dem Ladezustandswert der zu messenden
      Batterie anzugeben; und Bestimmen (206) eines momentanen Ladezustandswerts der zu messenden
      Batterie basierend auf der momentanen Coulomb-Kapazität und der momentanen nicht nutzbaren Kapazität.

2. Schätzverfahren nach Anspruch 1, wobei
   die erste Entsprechung Folgendes umfasst:

   wenn die Entladedauer kleiner oder gleich einem ersten Schwellenwert ist, ist der Innenwiderstandsreaktionstyp
   ein erster Reaktionstyp, und der erste Reaktionstyp umfasst einen ohmschen Widerstand;
   wenn die Entladedauer größer als ein erster Schwellenwert und kleiner oder gleich einem zweiten Schwellenwert
   ist, ist der Innenwiderstandsreaktionstyp ein zweiter Reaktionstyp, und der zweite Reaktionstyp umfasst einen
   ohmschen Widerstand und einen Ladungsübertragungswiderstand; oder

wenn die Entladedauer größer als ein zweiter Schwellenwert ist, ist der Innenwiderstandsreaktionstyp ein dritter Reaktionstyp, und der dritte Reaktionstyp umfasst einen ohmschen Widerstand, einen Ladungsübertragungswiderstand und eine Diffusionsimpedanz.

3. Schätzverfahren nach Anspruch 2, wobei das Bestimmen der momentanen Innenwiderstandsdaten der zu messenden Batterie, das auf dem momentanen Innenwiderstandsreaktionstyp, der momentanen Temperatur, dem momentanen Lade-/Entladestrom und dem vorherigen Ladezustandswert basiert, Folgendes umfasst:

Bestimmen einer zweiten Entsprechung basierend auf dem ersten Reaktionstyp, wobei die zweite Entsprechung dazu dient, eine Entsprechung zwischen dem ohmschen Widerstand der zu messenden Batterie und einer Temperatur und einem Ladezustandswert der zu messenden Batterie anzugeben; und
Bestimmen der momentanen Innenwiderstandsdaten der zu messenden Batterie basierend auf der zweiten Entsprechung, der momentanen Temperatur, dem momentanen Lade-/Entladestrom und dem vorherigen Ladezustandswert, wobei es sich bei den Innenwiderstandsdaten um einen momentanen ohmschen Widerstand handelt.

4. Schätzverfahren nach Anspruch 2, wobei das Bestimmen der momentanen Innenwiderstandsdaten der zu messenden Batterie, das auf dem momentanen Innenwiderstandsreaktionstyp, der momentanen Temperatur, dem momentanen Lade-/Entladestrom und dem vorherigen Ladezustandswert basiert, Folgendes umfasst:

Bestimmen einer zweiten Entsprechung und einer dritten Entsprechung basierend auf dem zweiten Reaktionstyp, wobei die zweite Entsprechung dazu dient, eine Entsprechung zwischen dem ohmschen Widerstand der zu messenden Batterie und einer Temperatur und einem Ladezustandswert der zu messenden Batterie anzugeben, und die dritte Entsprechung dazu dient, eine Entsprechung zwischen dem Ladungsübertragungswiderstand der zu messenden Batterie und der Temperatur, dem Ladezustand und dem Lade-/Entladestrom der zu messenden Batterie anzugeben; und
Bestimmen der momentanen Innenwiderstandsdaten der zu messenden Batterie basierend auf der zweiten Entsprechung, der dritten Entsprechung, der momentanen Temperatur, dem momentanen Lade-/Entladestrom und dem vorherigen Ladezustandswert, wobei es sich bei den Innenwiderstandsdaten um eine Summe aus dem momentanen ohmschen Widerstand und dem momentanen Ladungsübertragungswiderstand handelt.

5. Schätzverfahren nach Anspruch 2, wobei das Bestimmen der momentanen Innenwiderstandsdaten der zu messenden Batterie, das auf dem momentanen Innenwiderstandsreaktionstyp, der momentanen Temperatur, dem momentanen Lade-/Entladestrom und dem vorherigen Ladezustandswert basiert, Folgendes umfasst:

Bestimmen einer zweiten Entsprechung, einer dritten Entsprechung und einer vierten Entsprechung basierend auf dem dritten Reaktionstyp, wobei die zweite Entsprechung dazu dient, eine Entsprechung zwischen dem ohmschen Widerstand der zu messenden Batterie und einer Temperatur und einem Ladezustandswert der zu messenden Batterie anzugeben, die dritte Entsprechung dazu dient, eine Entsprechung zwischen dem Ladungsübertragungswiderstand der zu messenden Batterie und der Temperatur, dem Ladezustand und dem Lade-/Entladestrom der zu messenden Batterie anzugeben, und die vierte Entsprechung dazu dient, eine Entsprechung zwischen der Diffusionsimpedanz der zu messenden Batterie und der Temperatur, dem Ladezustandswert und dem Lade-/Entladestrom der zu messenden Batterie anzugeben; und
Bestimmen der momentanen Innenwiderstandsdaten der zu messenden Batterie basierend auf der zweiten Entsprechung, der dritten Entsprechung, der vierten Entsprechung, der momentanen Temperatur, dem momentanen Lade-/Entladestrom und dem vorherigen Ladezustandswert, wobei es sich bei den Innenwiderstandsdaten um eine Summe aus dem momentanen ohmschen Widerstand, dem momentanen Ladungsübertragungswiderstand und einer momentanen Diffusionsimpedanz handelt.

6. Schätzverfahren nach einem der Ansprüche 1 bis 5, wobei das Bestimmen eines momentanen Ladezustandswerts der zu messenden Batterie basierend auf der momentanen Coulomb-Kapazität und der momentanen nicht nutzbaren Kapazität Folgendes umfasst:

Bestimmen einer Anfangskapazität basierend auf einer vorkonfigurierten Vollladekapazität, dem vorherigen Ladezustandswert und der fünften Entsprechung, wobei die Anfangskapazität eine Kapazität der zu messenden Batterie zu einem vorherigen Zeitpunkt ist;
Bestimmen einer momentanen Restkapazität der zu messenden Batterie basierend auf der Anfangskapazität, der momentanen Coulomb-Kapazität und der momentanen nicht nutzbaren Kapazität; und
Bestimmen des momentanen Ladezustandswerts der zu messenden Batterie basierend auf der momentanen Restkapazität, der vorkonfigurierten Vollladekapazität und der momentanen nicht nutzbaren Kapazität.

7. Einrichtung (500) zum Schätzen eines Ladezustands einer Batterie, die Folgendes umfasst:

eine erste Ermittlungseinheit (601), die dazu konfiguriert ist, in einem vorkonfigurierten Zeitintervall einen momentanen Lade-/Entladestrom, eine momentane Temperatur,
eine momentane Coulomb-Kapazität und einen vorherigen Ladezustandswert einer zu messenden Batterie in Echtzeit zu ermitteln, wobei das vorkonfigurierte Zeitintervall die Zeitspanne zwischen einem vorherigen Zeitpunkt und einem momentanen Zeitpunkt ist;
eine zweite Ermittlungseinheit (602), die dazu konfiguriert ist, eine Entladedauer der zu messenden Batterie zu ermitteln, wobei die Entladedauer die Dauer eines Lade-/Entladestroms ist;
eine erste Bestimmungseinheit (603), die dazu konfiguriert ist, einen momentanen Innenwiderstandsreaktionstyp der zu messenden Batterie basierend auf der Entladedauer und einer vorkonfigurierten ersten Entsprechung zu bestimmen, wobei die erste Entsprechung dazu dient, eine Entsprechung zwischen der Entladedauer der zu messenden Batterie und dem Innenwiderstandsreaktionstyp der zu messenden Batterie anzugeben;
eine zweite Bestimmungseinheit (604), die dazu konfiguriert ist, momentane Innenwiderstandsdaten der zu messenden Batterie basierend auf dem momentanen Innenwiderstandsreaktionstyp, der momentanen Temperatur, dem momentanen Lade-/Entladestrom und dem vorherigen Ladezustandswert zu bestimmen;
eine dritte Bestimmungseinheit (605), die dazu konfiguriert ist, eine momentane nicht nutzbare Kapazität der zu messenden Batterie basierend auf den momentanen Innenwiderstandsdaten, dem momentanen Lade-/Entladestrom und der momentanen Temperatur zu bestimmen, wobei die nicht nutzbare Kapazität ein Ladezustandswert ist, wenn die zu messende Batterie keine Kapazität freigeben kann, und die dritte Bestimmungseinheit (605) insbesondere zu Folgendem konfiguriert ist:

Bestimmen einer momentanen Spannung über dem Innenwiderstand der zu messenden Batterie basierend auf den momentanen Innenwiderstandsdaten und dem momentanen Lade-/Entladestrom, wobei die Spannung über dem Innenwiderstand ein Spannungsverlust ist, der durch einen Innenwiderstand der zu messenden Batterie verursacht wird;
Bestimmen einer momentanen nicht nutzbaren Spannung der zu messenden Batterie basierend auf der momentanen Innenwiderstandsspannung und einer vorkonfigurierten Entladeschlussspannung und
Bestimmen der momentanen nicht nutzbaren Kapazität der zu messenden Batterie basierend auf der momentanen nicht nutzbaren Spannung, der momentanen Temperatur und einer vorkonfigurierten fünften Entsprechung, wobei die fünfte Entsprechung dazu dient, eine Entsprechung zwischen einer Leerlaufspannung der zu messenden Batterie und der Temperatur und dem Ladezustandswert der zu messenden Batterie anzugeben; und

eine vierte Bestimmungseinheit (606), die dazu konfiguriert ist, einen momentanen Ladezustandswert der zu messenden Batterie basierend auf der momentanen Coulomb-Kapazität und der momentanen nicht nutzbaren Kapazität zu bestimmen.

8. Schätzvorrichtung nach Anspruch 7, wobei die erste Entsprechung Folgendes umfasst:

wenn die Entladedauer kleiner oder gleich einem ersten Schwellenwert ist, ist der Innenwiderstandsreaktionstyp ein erster Reaktionstyp, und der erste Reaktionstyp umfasst einen ohmschen Widerstand;
wenn die Entladedauer größer als ein erster Schwellenwert und kleiner oder gleich einem zweiten Schwellenwert ist, ist der Innenwiderstandsreaktionstyp ein zweiter Reaktionstyp, und der zweite Reaktionstyp umfasst einen ohmschen Widerstand und einen Ladungsübertragungswiderstand; oder
wenn die Entladedauer größer als ein zweiter Schwellenwert ist, ist der Innenwiderstandsreaktionstyp ein dritter Reaktionstyp, und der dritte Reaktionstyp umfasst einen ohmschen Widerstand, einen Ladungsübertragungswiderstand und eine Diffusionsimpedanz.

9. Endgerät, das umfasst:

eine Batterie, und eine Einrichtung (500) zum Schätzen eines Ladezustands einer Batterie, wobei
die Einrichtung (500) zum Schätzen eines Ladezustands einer Batterie die Einrichtung (500) zum Schätzen eines Ladezustands einer Batterie nach Anspruch 7 oder 8 ist.

**10.** Computerprogrammprodukt, das Anweisungen einschließt, die bei Ausführung des Computerprogrammprodukts auf einem Computer den Computer veranlassen, das Verfahren nach einem der Ansprüche 1 bis 6 durchzuführen.

**Revendications**

**1.** Procédé permettant d'estimer un état de charge d'une batterie, comprenant :

l'obtention (201), dans un intervalle de temps préconfiguré, d'un courant de charge/décharge à l'instant présent, d'une température à l'instant présent, d'une capacité coulombienne à l'instant présent et d'une valeur d'état de charge à l'instant précédent d'une batterie à mesurer en temps réel, dans lequel l'intervalle de temps préconfiguré est une durée entre un instant précédent et un instant présent ;
l'obtention (202) d'une durée de décharge de la batterie à mesurer, dans lequel la durée de décharge est une durée d'un courant de charge/décharge ;
la détermination d'un type de réponse de résistance interne à l'instant présent de la batterie à mesurer sur la base de la durée de décharge et d'une première correspondance préconfigurée, dans lequel la première correspondance est utilisée pour indiquer une correspondance entre la durée de décharge de la batterie à mesurer et le type de réponse de résistance interne de la batterie à mesurer ;
la détermination (204) de données de résistance interne à l'instant présent de la batterie à mesurer sur la base du type de réponse de résistance interne à l'instant présent, de la température à l'instant présent, du courant de charge/décharge à l'instant présent et de la valeur d'état de charge à l'instant précédent ;
la détermination (205) d'une capacité inutilisable à l'instant présent de la batterie à mesurer sur la base des données de résistance interne à l'instant présent, du courant de charge/décharge à l'instant présent, et de la température à l'instant présent, dans lequel la capacité inutilisable est une valeur d'état de charge lorsque la batterie à mesurer ne peut pas libérer de capacité, et la détermination (205) d'une capacité inutilisable à l'instant présent de la batterie à mesurer sur la base des données de résistance interne à l'instant présent, du courant de charge/décharge à l'instant présent et de la température à l'instant présent comprend :

la détermination d'une tension de résistance interne à l'instant présent de la batterie à mesurer sur la base des données de résistance interne à l'instant présent et du courant de charge/décharge à l'instant présent, dans lequel la tension de résistance interne est une perte de tension causée par une résistance interne de la batterie à mesurer ;
la détermination d'une tension inutilisable à l'instant présent de la batterie à mesurer sur la base de la tension de résistance interne à l'instant présent et d'une tension de coupure préconfigurée ; et
la détermination de la capacité inutilisable à l'instant présent de la batterie à mesurer sur la base de la tension inutilisable à l'instant présent, de la température à l'instant présent et d'une cinquième correspondance préconfigurée, dans lequel la cinquième correspondance est utilisée pour indiquer une correspondance entre une tension en circuit ouvert de la batterie à mesurer, la température et la valeur d'état de charge de la batterie à mesurer ; et la détermination (206) d'une valeur d'état de charge à l'instant présent de la batterie à mesurer sur la base de la capacité coulombienne à l'instant présent et de la capacité inutilisable à l'instant présent.

**2.** Procédé d'estimation selon la revendication 1, dans lequel
la première correspondance comprend :

lorsque la durée de décharge est inférieure ou égale à un premier seuil, le type de réponse de résistance interne est un premier type de réponse, et le premier type de réponse comprend une résistance ohmique ;
lorsque la durée de décharge est supérieure à un premier seuil et inférieure ou égale à un second seuil, le type de réponse de résistance interne est un deuxième type de réponse, et le deuxième type de réponse comprend une résistance ohmique et une résistance de transfert de charge ; ou
lorsque la durée de décharge est supérieure à un second seuil, le type de réponse de résistance interne est un troisième type de réponse, et le troisième type de réponse comprend une résistance ohmique, une résistance de transfert de charge et une impédance de diffusion.

**3.** Procédé d'estimation selon la revendication 2, dans lequel la détermination de données de résistance interne à l'instant présent de la batterie à mesurer sur la base du type de réponse de résistance interne à l'instant présent, de la température à l'instant présent, du courant de charge/décharge à l'instant présent et de la valeur d'état de charge à l'instant précédent comprend :

la détermination d'une deuxième correspondance sur la base du premier type de réponse, dans lequel la deuxième correspondance est utilisée pour indiquer une correspondance entre la résistance ohmique de la batterie à mesurer et une température et une valeur d'état de charge de la batterie à mesurer ; et

la détermination des données de résistance interne à l'instant présent de la batterie à mesurer sur la base de la deuxième correspondance, de la température à l'instant présent, du courant de charge/décharge à l'instant présent et de la valeur d'état de charge à l'instant précédent, dans lequel les données de résistance interne représentent une résistance ohmique à l'instant présent.

**4.** Procédé d'estimation selon la revendication 2, dans lequel la détermination de données de résistance interne à l'instant présent de la batterie à mesurer sur la base du type de réponse de résistance interne à l'instant présent, de la température à l'instant présent, du courant de charge/décharge à l'instant présent et de la valeur d'état de charge à l'instant précédent comprend :

la détermination d'une deuxième correspondance et d'une troisième correspondance sur la base du deuxième type de réponse, dans lequel la deuxième correspondance est utilisée pour indiquer une correspondance entre la résistance ohmique de la batterie à mesurer, une température et une valeur d'état de charge de la batterie à mesurer, et la troisième correspondance est utilisée pour indiquer une correspondance entre la résistance de transfert de charge de la batterie à mesurer, la température, l'état de charge et le courant de charge/décharge de la batterie à mesurer ; et

la détermination des données de résistance interne à l'instant présent de la batterie à mesurer sur la base de la deuxième correspondance, de la troisième correspondance, de la température à l'instant présent, du courant de charge/décharge à l'instant présent et de la valeur d'état de charge à l'instant précédent, dans lequel les données de résistance interne représentent une somme d'une résistance ohmique à l'instant présent et d'une résistance de transfert de charge à l'instant présent.

**5.** Procédé d'estimation selon la revendication 2, dans lequel la détermination de données de résistance interne à l'instant présent de la batterie à mesurer sur la base du type de réponse de résistance interne à l'instant présent, de la température à l'instant présent, du courant de charge/décharge à l'instant présent et de la valeur d'état de charge à l'instant précédent comprend :

la détermination d'une deuxième correspondance, d'une troisième correspondance, et d'une quatrième correspondance sur la base du troisième type de réponse, dans lequel la deuxième correspondance est utilisée pour indiquer une correspondance entre la résistance ohmique de la batterie à mesurer, et une température et une valeur d'état de charge de la batterie à mesurer, la troisième correspondance est utilisé pour indiquer une correspondance entre la résistance de transfert de charge de la batterie à mesurer, et la température, l'état de charge, et le courant de charge/décharge de la batterie à mesurer, et la quatrième correspondance est utilisée pour indiquer une correspondance entre l'impédance de diffusion de la batterie à mesurer, et la température, la valeur d'état de charge, et le courant de charge/décharge de la batterie à mesurer ; et

la détermination des données de résistance interne à l'instant présent de la batterie à mesurer sur la base de la deuxième correspondance, de la troisième correspondance, de la quatrième correspondance, de la température à l'instant présent, du courant de charge/décharge à l'instant présent et de la valeur d'état de charge à l'instant précédent, dans lequel les données de résistance interne représentent une somme d'une résistance ohmique à l'instant présent, d'une résistance de transfert de charge à l'instant présent et d'une impédance de diffusion à l'instant présent.

**6.** Procédé d'estimation selon l'une quelconque des revendications 1 à 5, dans lequel la détermination d'une valeur d'état de charge à l'instant présent de la batterie à mesurer sur la base de la capacité coulombienne à l'instant présent et de la capacité inutilisable à l'instant présent comprend :

la détermination d'une capacité initiale sur la base d'une capacité de charge complète préconfigurée, de la valeur d'état de charge à l'instant précédent et de la cinquième correspondance, dans lequel la capacité initiale est une capacité à l'instant précédent de la batterie à mesurer ;

la détermination d'une capacité résiduelle à l'instant présent de la batterie à mesurer sur la base de la capacité initiale, de la capacité coulombienne à l'instant présent et de la capacité inutilisable à l'instant présent ; et

la détermination de la valeur d'état de charge à l'instant présent de la batterie à mesurer sur la base de la capacité résiduelle à l'instant présent, de la capacité de charge complète préconfigurée et de la capacité inutilisable à l'instant présent.

**7.** Appareil (500) permettant d'estimer un état de charge d'une batterie, comprenant :

une première unité d'obtention (601), configurée pour obtenir, dans un intervalle de temps préconfiguré, un courant de charge/décharge à l'instant présent, une température à l'instant présent, une capacité coulombienne à l'instant présent et une valeur d'état de charge à l'instant précédent d'une batterie à mesurer en temps réel, dans lequel l'intervalle de temps préconfiguré est une durée entre un instant précédent et un instant présent ;
une seconde unité d'obtention (602), configurée pour obtenir une durée de décharge de la batterie à mesurer, dans lequel la durée de décharge est une durée d'un courant de charge/décharge ;
une première unité de détermination (603), configurée pour déterminer un type de réponse de résistance interne à l'instant présent de la batterie à mesurer sur la base de la durée de décharge et d'une première correspondance préconfigurée, dans lequel la première correspondance est utilisée pour indiquer une correspondance entre la durée de décharge de la batterie à mesurer et le type de réponse de résistance interne de la batterie à mesurer ;
une deuxième unité de détermination (604), configurée pour déterminer des données de résistance interne à l'instant présent de la batterie à mesurer sur la base du type de réponse de résistance interne à l'instant présent, de la température à l'instant présent, du courant de charge/décharge à l'instant présent et de la valeur d'état de charge à l'instant précédent ;
une troisième unité de détermination (605), configurée pour déterminer une capacité inutilisable à l'instant présent de la batterie à mesurer sur la base des données de résistance interne à l'instant présent, du courant de charge/décharge à l'instant présent et de la température à l'instant présent, dans lequel la capacité inutilisable est une valeur d'état de charge lorsque la batterie à mesurer ne peut pas libérer de capacité, et la troisième unité de détermination (605) est particulièrement configurée pour :

déterminer une tension de résistance interne à l'instant présent de la batterie à mesurer sur la base des données de résistance interne à l'instant présent et du courant de charge/décharge à l'instant présent, dans lequel la tension de résistance interne est une perte de tension causée par une résistance interne de la batterie à mesurer ;
déterminer une tension inutilisable à l'instant présent de la batterie à mesurer sur la base de la tension de résistance interne à l'instant présent et d'une tension de coupure préconfigurée ; et
déterminer la capacité inutilisable à l'instant présent de la batterie à mesurer sur la base de la tension inutilisable à l'instant présent, de la température à l'instant présent et d'une cinquième correspondance préconfigurée, dans lequel la cinquième correspondance est utilisée pour indiquer une correspondance entre une tension en circuit ouvert de la batterie à mesurer, la température et la valeur d'état de charge de la batterie à mesurer ; et
une quatrième unité de détermination (606), configurée pour déterminer une valeur d'état de charge à l'instant présent de la batterie à mesurer sur la base de la capacité coulombienne à l'instant présent et de la capacité inutilisable à l'instant présent.

**8.** Appareil d'estimation selon la revendication 7, dans lequel la première correspondance comprend :

lorsque la durée de décharge est inférieure ou égale à un premier seuil, le type de réponse de résistance interne est un premier type de réponse, et le premier type de réponse comprend une résistance ohmique ;
lorsque la durée de décharge est supérieure à un premier seuil et inférieure ou égale à un second seuil, le type de réponse de résistance interne est un deuxième type de réponse, et le deuxième type de réponse comprend une résistance ohmique et une résistance de transfert de charge ; ou
lorsque la durée de décharge est supérieure à un second seuil, le type de réponse de résistance interne est un troisième type de réponse, et le troisième type de réponse comprend une résistance ohmique, une résistance de transfert de charge et une impédance de diffusion.

**9.** Terminal, comprenant :

une batterie, et un appareil (500) permettant d'estimer un état de charge d'une batterie, dans lequel l'appareil (500) permettant d'estimer un état de charge d'une batterie est l'appareil (500) permettant d'estimer un état de charge d'une batterie selon la revendication 7 ou 8.

**10.** Produit-programme informatique comportant des instructions, qui, lorsque le produit-programme informatique est exécuté sur un ordinateur, amènent l'ordinateur à réaliser le procédé selon l'une quelconque des revendications 1 à 6.

FIG. 1A

FIG. 1B

FIG. 1C

Obtain, at a preconfigured time interval, a current-moment charge/discharge current, a current-moment temperature, a current-moment coulomb capacity, and a previous-moment state of charge value of a to-be-measured battery in real time ⟋⎯ 201

↓

Obtain discharge duration of the to-be-measured battery ⟋⎯ 202

↓

Determine a current-moment internal resistance response type of the to-be-measured battery based on the discharge duration ⟋⎯ 203

↓

Determine current-moment internal resistance data of the to-be-measured battery based on the current-moment internal resistance response type, the current-moment temperature, the current-moment charge/discharge current, and the previous-moment state of charge value ⟋⎯ 204

↓

Determine a current-moment unusable capacity of the to-be-measured battery based on the current-moment internal resistance data, the current-moment charge/discharge current, and the current-moment temperature ⟋⎯ 205

↓

Determine a current-moment state of charge value of the to-be-measured battery based on the current-moment coulomb capacity and the current-moment unusable capacity ⟋⎯ 206

FIG. 2

FIG. 3

FIG. 4

FIG. 5

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2439550 A1

**Non-patent literature cited in the description**

- Adaptive state of charge algorithm for nickel metal hydride batteries including hysteresis phenomena. **VERBRUGGE M et al.** JOURNAL OF POWER SOURCES. ELSEVIER, 16 February 2004, vol. 126, 236-249